# EUROPEAN PATENT APPLICATION

(11) **EP 4 336 259 A1**
(43) Date of publication of application: **13.03.2024**
(21) Application number: 23178872.0
(22) Date of filing: 13.06.2023
(51) Int. Cl.: G03F 7/00, H01L 23/544

(54) **SEMICONDUCTOR DEVICE AND METHOD OF FABRICATING THE SAME**

(30) Priority: 30.08.2022 KR 20220108981
(71) Applicant: Samsung Electronics Co., Ltd., Suwon-si, Gyeonggi-do 16677 (KR)
(72) Inventor: LEE, SeungKyo, 16677 Suwon-si (KR); KIM, Hyuncheol, 16677 Suwon-si (KR); JUNG, Woojin, 16677 Suwon-si (KR)
(74) Representative: Marks & Clerk LLP

(57) **Abstract**

A semiconductor device may include a substrate including a chip region and an edge region enclosing the chip region, and at least one coarse key pattern divided into fine key patterns on the edge region, extend in a first direction and are spaced apart from each other in a second direction crossing the first direction. Each of the fine key patterns may include a first key pattern, extending in the first direction, and a second key pattern including a first portion extending along a side surface of the first key pattern, and a second portion extending along an opposite side surface of the first key pattern. A width of each of the first and second portions may be smaller than a width of the first key pattern, when measured in the second direction.

## Description

### BACKGROUND

Example embodiments relate to a semiconductor, and in particular, to a semiconductor device and/or a method of fabricating the same.

Due to their small-sized, multifunctional, and/or low-cost characteristics, semiconductor devices are being esteemed as important elements in the electronics industry. The semiconductor devices may be classified into a memory device for storing data, a logic device for processing data, and a hybrid device including both of memory and logic elements.

Due to the recent increasing demand for electronic devices with a fast speed and/or low power consumption, the semiconductor device requires or uses a fast operating speed and/or a low operating voltage. To satisfy or at least partially satisfy the above, it is necessary or desirable to increase an integration density of the semiconductor device. As the integration density of the semiconductor device increases, a pattern size of the semiconductor device decreases, and this may lead to various technical problems in a process of fabricating the semiconductor device. Thus, many studies are conducted to reduce a process failure in the process of fabricating the semiconductor device.

### SUMMARY

Various example embodiments provide a method of reducing a process failure in a process of fabricating a semiconductor device.

Alternatively or additionally, various example embodiments provide a process-monitoring structure, which is configured to allow for an easier process-monitoring process, and a semiconductor device including the same.

According to some example embodiments, a semiconductor device may include a substrate including a chip region and an edge region enclosing the chip region, and at least one coarse key pattern divided into fine key patterns, on the edge region, extend in a first direction, and are spaced apart from each other in a second direction crossing the first direction. Each of the fine key patterns may include a first key pattern extending in the first direction, and a second key pattern including a first portion extending along a side surface of the first key pattern, and a second portion extending along an opposite side surface of the first key pattern. A width of each of the first and second portions may be smaller than a width of the first key pattern, when measured in the second direction.

According to various example embodiments, a semiconductor device may include a substrate including a chip region and an edge region enclosing the chip region, word lines extended in a first direction on the chip region and spaced apart from each other in a second direction crossing the first direction, and fine key patterns extending in the first direction on the edge region and spaced apart from each other in the second direction. The fine key patterns may include the same material as at least a portion of the word lines, and a first pitch of each of the fine key patterns may be larger than a second pitch of four adjacent ones of the word lines, when measured in the second direction.

According to some example embodiments, a semiconductor device may include a substrate including a chip region and an edge region enclosing the chip region, word lines extended in a first direction on the chip region and spaced apart from each other in a second direction crossing the first direction, and fine key patterns extending in the first direction on the edge region and spaced apart from each other in the second direction. Each of the fine key patterns may include a first key pattern that extends in the first direction, and a second key pattern that extends along opposite side surfaces of the first key pattern. A width of the first key pattern may be larger than a distance between adjacent ones of the word lines, when measured in the second direction.

According to some example embodiments, a method of fabricating a semiconductor device may include sequentially forming a first mask layer, a second mask layer, a third mask layer, and a photoresist pattern on a substrate that includes a chip region and a scribe lane region, patterning the third mask layer using the photoresist pattern to form a third mask pattern, forming first spacers to cover side surfaces of the third mask pattern, etching the second mask layer using the first spacers as an etch mask to form a second mask pattern having a trench region that extends in a first direction, forming second spacers to cover side surfaces of the second mask pattern, forming an additional mask pattern to fill the trench region, and etching the first mask layer using the second mask pattern and the additional mask pattern as an etch mask to form a first mask pattern. A third pitch of the photoresist pattern on the scribe lane region may be larger than a fourth pitch of the photoresist pattern on the chip region, when measured in a second direction crossing the first direction.

At least some of the above and other features of the invention are set out in the claims.

### BRIEF DESCRIPTION OF THE DRAWINGS

FIG. 1 is a diagram illustrating a substrate, on which semiconductor devices according to some example embodiments are integrated.
FIG. 2 is an enlarged view illustrating a portion 'P' of FIG. 1.
FIGS. 3A to 3C are enlarged views illustrating a portion `PM1' of FIG. 2.
FIGS. 4 and 5 are enlarged views illustrating portions Pa and Pb, respectively, in FIGS. 3A to 3C.
FIG. 6 is a sectional view taken along a line A-A' of FIG. 4.
FIG. 7 is an enlarged view of a portion `PC' of FIG. 2.
FIGS. 8 and 9 are sectional views, which are respectively taken along lines B-B' and C-C' of FIG. 7.
FIG. 10 is an enlarged view illustrating a portion 'P' of FIG. 1.
FIGS. 11A to 11C are enlarged views illustrating a portion 'PM2' of FIG. 10.
FIGS. 12 to 35 are diagrams illustrating a method of fabricating a semiconductor device, according to some example embodiments.

### DETAILED DESCRIPTION

Various example embodiments will now be described more fully with reference to the accompanying drawings, in which example embodiments are shown.

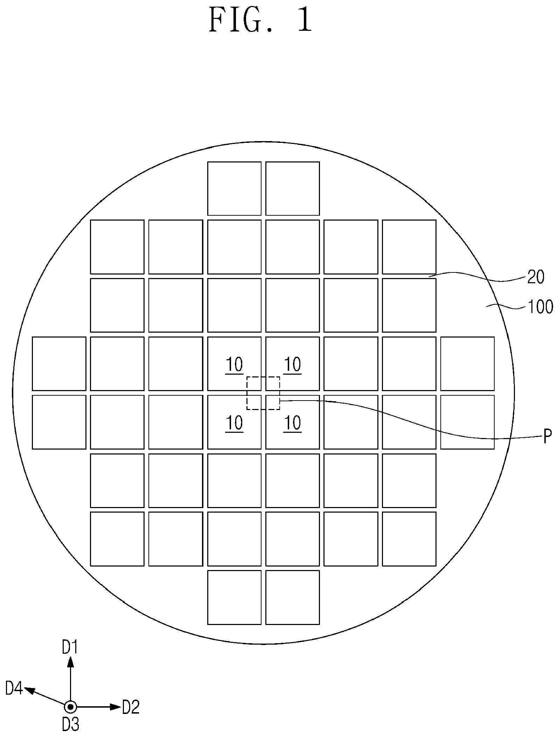

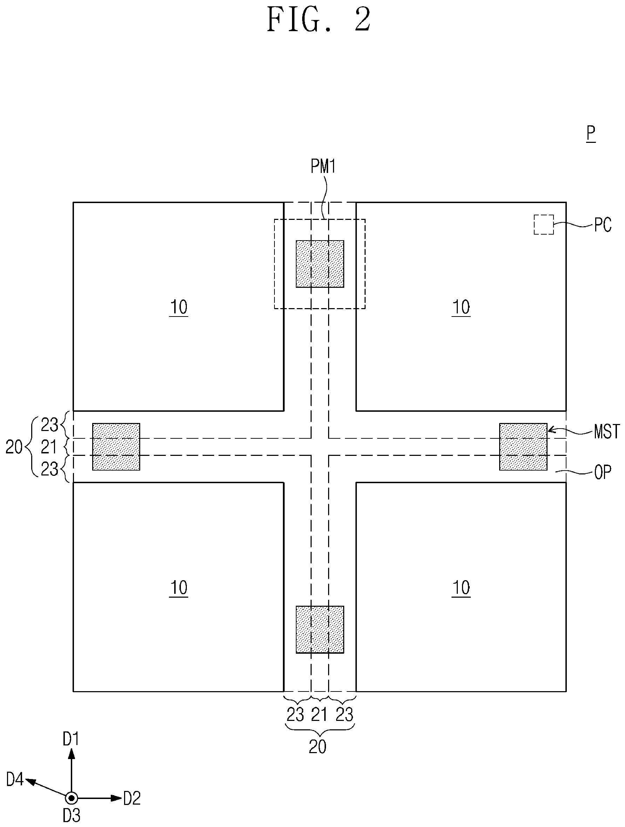

FIG. 1 is a diagram illustrating a substrate, on which semiconductor devices according to some example embodiments are integrated. FIG. 2 is an enlarged view illustrating a portion 'P' of FIG. 1.

Referring to FIGS. 1 and 2, a substrate 100 may include chip regions 10, in which semiconductor integrated circuits are provided, and a scribe lane region 20 between the chip regions 10. The substrate 100 may be a semiconductor substrate (e.g., a silicon wafer, a germanium wafer, or a silicon-germanium wafer). The substrate 100 may be circular; however, example embodiments are not limited thereto. A diameter of the substrate 100 may be 100 mm, or 200 mm, or 300 mm, or 450 mm; however, example embodiments are not limited thereto. The substrate 100 may include a notch region (not illustrated) and/or a flat region (not illustrated). As used herein, each of the expressions of "A or B", "at least one of A and B", "at least one of A or B", "A, B, or C", "at least one of A, B, and C", and "at least one of A, B, or C" may be used to represent one of the elements enumerated in the expression or any possible combination of the enumerated elements.

The chip regions 10 may be two-dimensionally arranged in a first direction D1 and a second direction D2, which are non-parallel (e.g., orthogonal) to each other. Each of the first and second directions D1 and D2 may be parallel to a bottom surface of the substrate 100. Each of the chip regions 10 may be surrounded by the scribe lane region 20. Each of the chip regions 10 may be rectangular, e.g. square or non-square; however, example embodiments are not limited thereto. A size, e.g. an area, of each of the chip regions 10 may be the same as each other; however, example embodiments are not limited thereto.

The scribe lane region 20 may include a plurality of first scribe lane regions, which are extended in the first direction D1, and a plurality of second scribe lane regions, which are extended in the second direction D2 to cross the first scribe lane regions. The scribe lane region 20 may include a kerf or cutting region 21, which will be cut by a sawing and/or cutting machine, and edge regions 23 between the cutting region 21 and the chip regions 10. The edge regions 23 may be provided to surround or enclose the chip regions 10, respectively. As an example, when viewed in a plan view, the cutting region 21 may be interposed between adjacent ones of the chip regions 10, and the edge regions 23 may be interposed between the chip regions 10 and the cutting region 21.

Semiconductor devices may be provided on the chip regions 10 of the substrate 100. As an example, the semiconductor memory device provided on the chip regions 10 may be one or more of a dynamic random access memory (DRAM) device, a static random access memory (SRAM) device, a NAND FLASH memory device, a resistive random access memory (RRAM) device, or the like. Alternatively or additionally, a processor, such as one or more of a micro-electromechanical system (MEMS) device, an optoelectronic device, a central processing unit (CPU), or a digital signal processor (DSP), may be provided on the chip region 10 as the semiconductor memory device. Alternatively or additionally, standard cells including semiconductor devices, such as an OR gate or an AND gate, may be provided on the chip regions 10 of the substrate 100.

A process-monitoring structure MST and an outer pattern OP may be provided on the scribe lane region 20 of the substrate 100. The process-monitoring structure MST may include monitoring patterns which are used to monitor whether and how processes (e.g., a patterning process) of fabricating a semiconductor device are performed, e.g. properly performed. For example, the process-monitoring structure MST may include monitoring patterns that include one or more of an alignment pattern used as a reference point in a step of aligning patterns, an overlay pattern used to examine an overlay state between lower and upper patterns, or a measurement pattern used to measure thicknesses and linewidths of patterns. The process-monitoring structure MST may be placed on the cutting region 21 and the edge regions 23. The outer pattern OP may include patterns, which are placed on the scribe lane region 20 and are different from the process-monitoring structure MST. In some example embodiments, a portion of the outer pattern OP may be provided to enclose the process-monitoring structure MST.

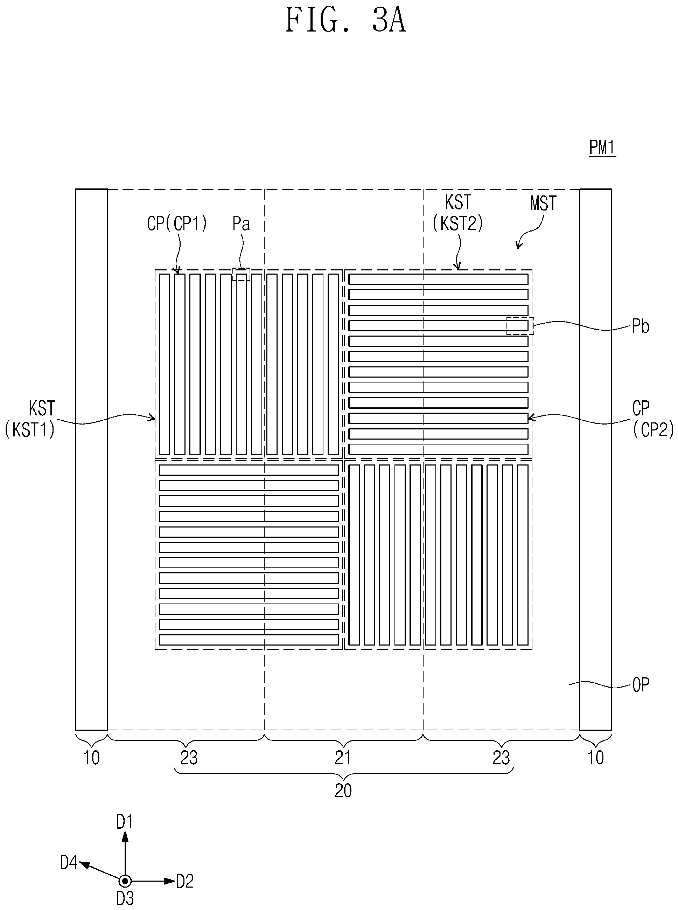

FIGS. 3A to 3C are enlarged views illustrating a portion `PM1' of FIG. 2. Hereinafter, key structures in the process-monitoring structure and coarse key patterns constituting the key structures will be described in more detail with reference to FIGS. 3A to 3C.

Referring to FIGS. 3A to 3C, the process-monitoring structure MST may include a plurality of key structures KST, and each of the key structures KST may include a plurality of coarse key patterns CP. In some example embodiments, the process-monitoring structure MST may include a number, such as four, key structures KST, but example embodiments are not limited to this example. Nevertheless, for brevity's sake, some features of the key structures KST will be described in more detail with reference to the example of the process-monitoring structure MST illustrated in FIGS. 3A to 3C (e.g., including four key structures KST arranged in a 2-by-2 shape).

The key structures KST may include a first key structure KST1 and a second key structure KST2. In some example embodiments, each of the first and second key structures KST1 and KST2 may be provided in plural. As an example, each of the first and second key structures KST1 and KST2 may be composed of a pair of key structures. Here, one of the first key structures KST1 may be disposed to be adjacent to one of the second key structures KST2 in the first direction D1, and the other of the first key structures KST1 may be disposed to be adjacent to the one of the second key structures KST2 in the second direction D2. The other of the second key structures KST2 may be disposed to be adjacent to the one of the first key structures KST1 in the second direction D2 and to be adjacent to the other of the first key structures KST1 in the first direction D1.

The first key structure KST1 may include a first coarse key pattern CP1 of the coarse key patterns CP. The first key structure KST1 may include a plurality of first coarse key patterns CP1, which extend in the first direction D1. The first coarse key patterns CP1 may be spaced apart from each other in the second direction D2. The first key structure KST1 may include a row of the first coarse key patterns CP1, which are disposed along the second direction D2.

The second key structure KST2 may include a second coarse key pattern CP2 of the coarse key patterns CP. The second key structure KST2 may include a plurality of second coarse key patterns CP2, which extend in the second direction D2. The second coarse key patterns CP2 may be spaced apart from each other in the first direction D1. The second key structure KST2 may include a row of the second coarse key patterns CP2, which are disposed along the first direction D1.

For example, each of the key structures KST may be composed of or be wholly or at least partially partitioned or divided into a plurality of coarse key patterns CP, as shown in FIG. 3A. As an example, the first key structure KST1 may be composed of the first coarse key patterns CP1, which are arranged along the second direction D2, and the second key structure KST2 may be composed of the second coarse key patterns CP2, which are arranged along the first direction D1. Here, when viewed in a sectional view, other patterns, which are vertically overlapped with the key structures KST, may be provided at levels different from the key structures KST.

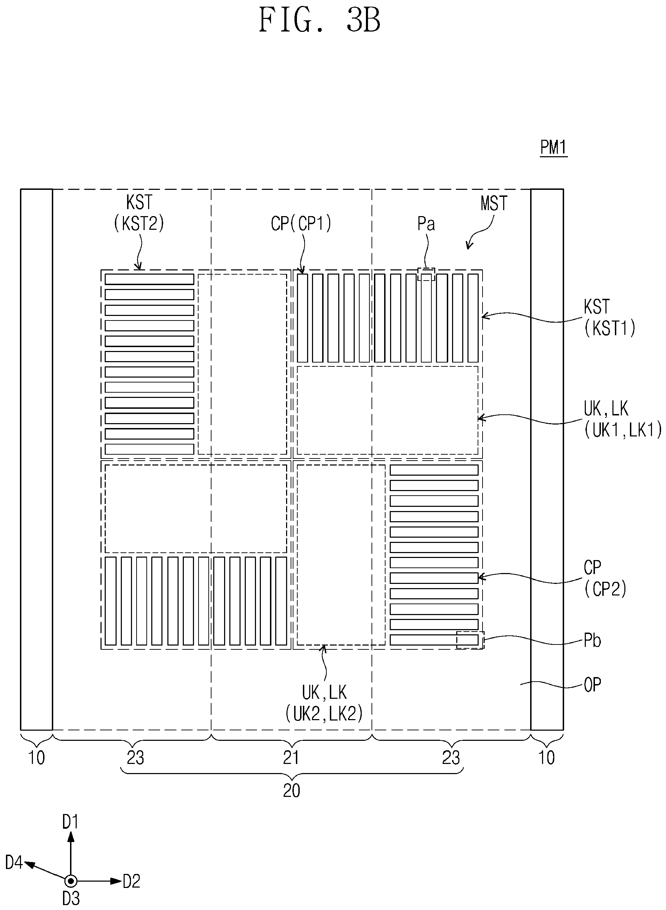

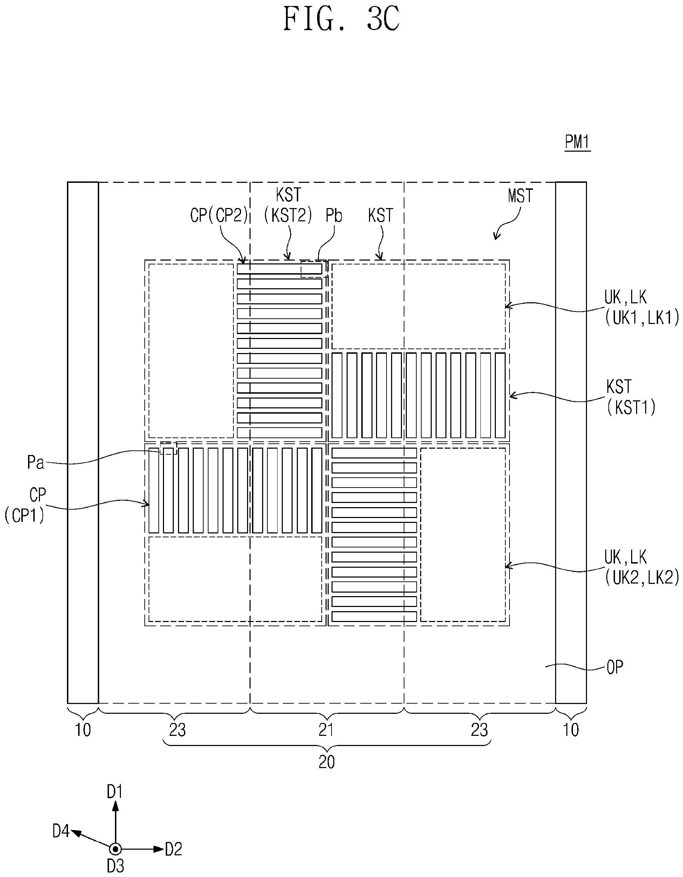

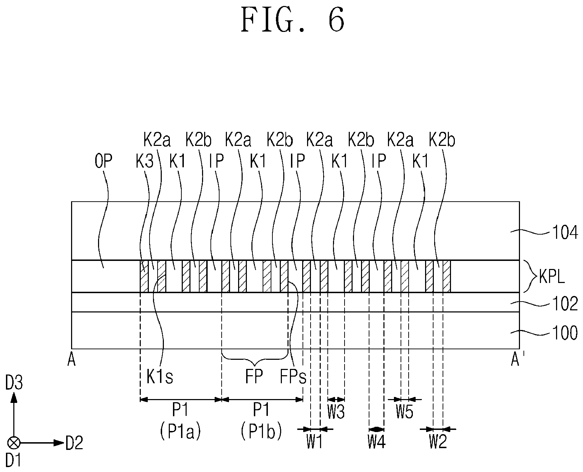

For example, as shown in FIGS. 3B and 3C, each of the key structures KST may include one, e.g. only one, of an upper key pattern UK or a lower key pattern LK. In detail, the first key structure KST1 may include one of a first upper key pattern UK1 or a first lower key pattern LK1, and the second key structure KST2 may include one of a second upper key pattern UK2 or a second lower key pattern LK2. When viewed in a plan view, the first upper or lower key patterns UK1 or LK1 may be extended in the second direction D2 and may be spaced apart from the group of the first coarse key patterns CP1 in the first direction D1. When viewed in a plan view, the second upper or lower key patterns UK2 and LK2 may be extended in the first direction D1 and may be spaced apart from the group of the second coarse key patterns CP2 in the second direction D2. When viewed in a sectional view, the upper key pattern UK may be located at a level higher than the coarse key patterns CP, and the lower key pattern LK may be located at a level lower than the coarse key patterns CP. This will be described in more detail with reference to FIG. 6.

In some example embodiments, when compared with the coarse key patterns CP, the upper or lower key patterns UK and LK may be disposed to be adjacent to a center region of the process-monitoring structure MST, as shown in FIG. 3B. As an example, when viewed in a plan view, the group of the first coarse key patterns CP1 may be spaced apart from the group of the second coarse key patterns CP2, in the first direction D1, with the first upper or lower key patterns UK1 or LK1 interposed therebetween. As another example, when viewed in a plan view, the group of the second coarse key patterns CP2 may be spaced apart from the group of the first coarse key patterns CP1, in the second direction D2, with the second upper or lower key patterns UK2 and LK2 interposed therebetween.

In some example embodiments, when compared with the upper or lower key patterns UK and LK, the coarse key patterns CP may be disposed to be adjacent to the center region of the process-monitoring structure MST, as shown in FIG. 3C. As an example, when viewed in a plan view, the first upper or lower key patterns UK1 or LK1 may be spaced apart from the second upper or lower key patterns UK2 and LK2, in the first direction D1, with the group of the first coarse key patterns CP1 interposed therebetween. As another example, when viewed in a plan view, the second upper or lower key patterns UK2 and LK2 may be spaced apart from the first upper or lower key patterns UK1 or LK1, in the second direction D2, with the group of the second coarse key patterns CP2 interposed therebetween.

However, the features of the key structures KST described with reference to FIGS. 3A to 3C are just an example of the inventive concept, and example embodiments are not limited to this example.

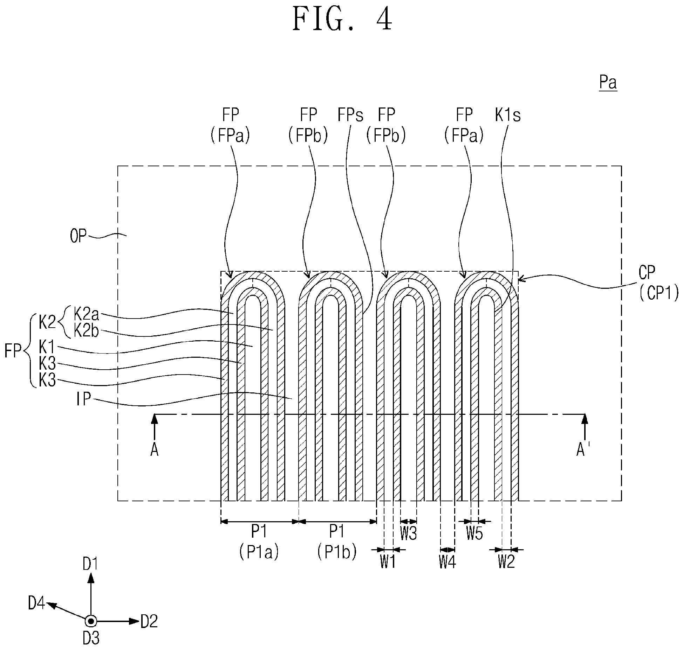

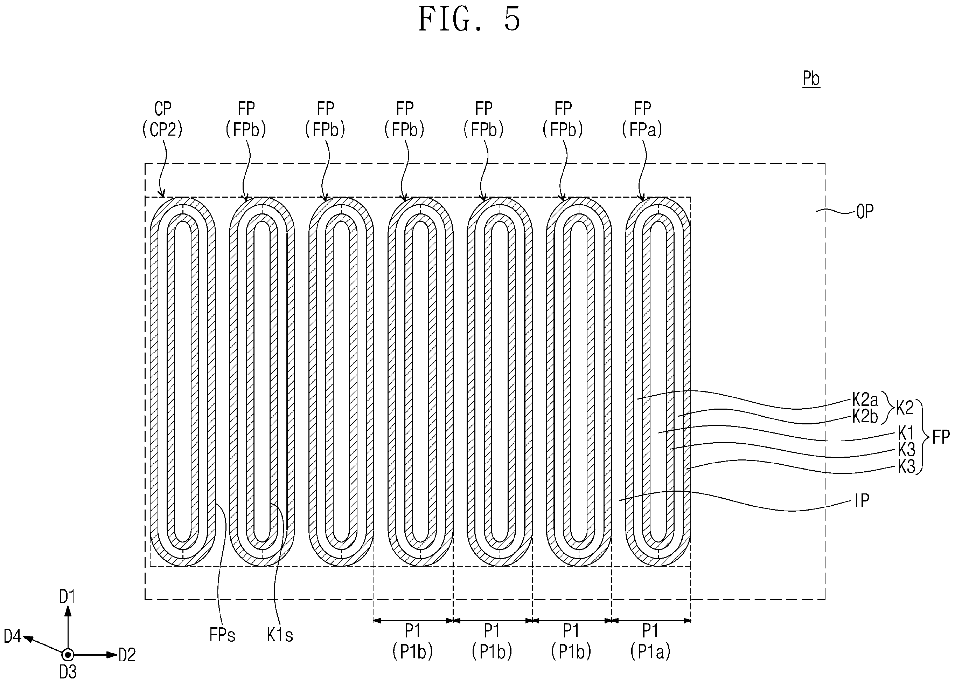

FIGS. 4 and 5 are enlarged views illustrating portions Pa and Pb, respectively, in FIGS. 3A to 3C. FIG. 6 is a sectional view taken along a line A-A' of FIG. 4. Hereinafter, fine key patterns constituting the coarse key patterns will be described in more detail with reference to FIGS. 4 and 5.

Referring to FIGS. 4 to 6, each of the coarse key patterns CP may include or, wholly or at least partially, be partitioned into or divided into a plurality of fine key patterns FP, which extend in the first direction D1, and inner patterns IP between the fine key patterns FP. The fine key patterns FP may be spaced apart from each other in the second direction D2, and the inner patterns IP may be located between the fine key patterns FP, which are adjacent to each other in the second direction D2. The inner patterns IP may be extended along side surfaces FPs of the fine key patterns FP or in the first direction D1 and may be spaced apart from each other in the second direction D2.

Each of the first and second coarse key patterns CP1 and CP2 may include or be wholly or at least partially divided into or partition into a plurality of fine key patterns FP. The number of the fine key patterns FP in each of the first coarse key patterns CP1 may be less than the number of the fine key patterns FP in each of the second coarse key patterns CP2. As an example, each of the first coarse key patterns CP1 may include four fine key patterns FP, and the number of the fine key patterns FP in each of the second coarse key patterns CP2 may be greater than this. In the first direction D1, a length of the fine key pattern FP of the first coarse key pattern CP1 may be longer than a length of the fine key pattern FP of the second coarse key pattern CP2. In the first direction D1, a length of the first coarse key pattern CP1 may be defined as the length of the fine key pattern FP of the first coarse key pattern CP1. In the first direction D1, a width of the second coarse key pattern CP2 may be defined as the length of the fine key pattern FP of the second coarse key pattern CP2.

The fine key patterns FP may be provided to have a first pitch P1 in the second direction D2As used herein, the first pitch P 1 of the fine key pattern FP may be defined as a width of each of unit regions, which are repeated in the second direction D2 and each of which includes one fine key pattern FP and one inner pattern IP. The first pitch P1 may be substantially equal to a sum of widths of one fine key pattern FP and one inner pattern IP. The first pitch P1 may range from 80 nm to 150 nm. In a case where the first pitch P1 is less than 80 nm, there may be a difficulty in forming fine patterns (e.g., first key pattern K1 to be described below) in the fine key pattern FP. In a case where the first pitch P1 is larger than 150 nm, the process-monitoring structure MST may have a pattern, which is excessively larger than a pattern in the semiconductor device on the chip region 10, and this may lead a difficulty in the process-monitoring operation.

The fine key patterns FP of each of the coarse key patterns CP may include a first fine key pattern FPa, which is placed at the outermost position in the second direction D2, and a second fine key pattern FPb, which is placed inside the coarse key pattern CP. In some example embodiments, each of the coarse key patterns CP may include a pair of first fine key patterns FPa, which are placed at opposite ends in the second direction D2, and a plurality of second fine key patterns FPb, which are placed between the pair of first fine key patterns FPa. A first pitch P1a of the first fine key pattern FPa may be different from a first pitch P1b of the second fine key pattern FPb. As an example, the first pitch P1a of the first fine key pattern FPa may be larger, equal to, or smaller than the first pitch P1b of the second fine key pattern FPb.

Each of the fine key patterns FP may include a first key pattern K1, a second key pattern K2, and a third key patterns K3. The first key pattern K1 may extend in the first direction D1. The second key pattern K2 may extend along opposite side surfaces K1s of the first key pattern K1 and in the first direction D1. As an example, when viewed in a plan view, the second key pattern K2 may be provided to enclose the first key pattern K1. The second key pattern K2 may have a shape such as hollow elliptical shape that is elongated in the first direction D1, and the first key pattern K1 may be placed in such a hollow elliptical pattern. The second key pattern K2 may include a first portion K2a, which extends along one of the opposite side surfaces K1s of the first key pattern K1, and a second portion K2b, which extends along the other of the opposite side surfaces K1s of the first key pattern K1. The first portion K2a, the first key pattern K1, and the second portion K2b may be sequentially disposed in the second direction D2. The third key patterns K3 may be interposed between the first key pattern K1 and the second key pattern K2 and between the second key pattern K2 and the inner pattern IP. The fine key patterns FP and the inner patterns IP may be alternately disposed in the second direction D2. As an example, the first portions K2a, the first key patterns K1, the second portions K2b, and the inner patterns IP may be alternately disposed in the second direction D2.

Each of the first portion K2a, the second portion K2b, the first key pattern K1, the inner pattern IP, and the third key pattern K3 may have a width in the second direction D2. The width of the first portion K2a may be defined as a first width W1. The width of the second portion K2b may be defined as a second width W2. The width of the first key pattern K1 may be defined as a third width W3. The width of the inner pattern IP may be defined as a fourth width W4. Here, the fourth width W4 may be substantially equal to a distance between adjacent ones of the fine key patterns FP. The width of the third key pattern K3 may be defined as a fifth width W5.

The first width W1 may or may not be substantially equal to the second width W2. The third width W3 may be greater than each of the first and second widths W1 and W2. The fourth width W4 may be greater than each of the first and second widths W1 and W2. As an example, a value, which is obtained by subtracting each of the first and second widths W1 and W2 from each of the third and fourth widths W3 and W4, may be greater than 0 nm and may be less than or equal to 10 nm. The third width W3 and the fourth width W4 may be substantially equal to or different from each other. Since the third key patterns K3 are provided in plural, a plurality of fifth widths W5 may be defined, and values of the fifth widths W5 may be substantially equal to each other.

When viewed in a sectional view, as shown in FIG. 6, the substrate 100, a lower pattern layer 102, a key pattern layer KPL, and an upper pattern layer 104 may be sequentially disposed in a third direction D3. The third direction D3 may be a direction perpendicular to the bottom surface of the substrate 100.

The fine key patterns FP and the inner patterns IP may be disposed in the key pattern layer KPL. The lower pattern layer 102 may be located between the key pattern layer KPL and the substrate 100. As an example, the lower pattern layer 102 may include a portion of the substrate 100 (e.g., a portion of an upper portion of the substrate 100). As another example, the lower pattern layer 102 may be formed of or include all or at least one material different from the substrate 100 and the key pattern layer KPL. However, example embodiments are not limited to this example, and the lower pattern layer 102 may include various materials and various patterns. The upper pattern layer 104 may be placed on the key pattern layer KPL. Similar to the lower pattern layer 102, the upper pattern layer 104 may include various materials and various patterns. As an example, the lower pattern layer 102 and the upper pattern layer 104 may include the lower key pattern LK and the upper key pattern UK of FIG. 3B, respectively.

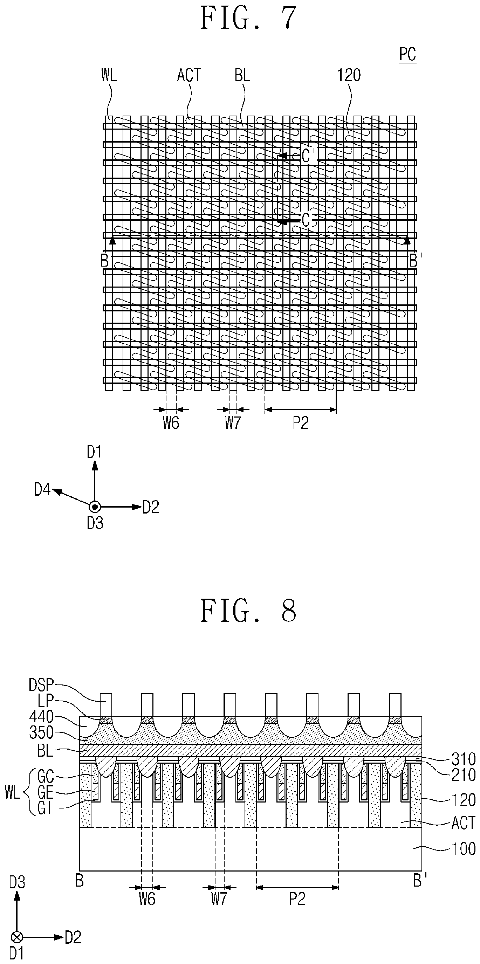

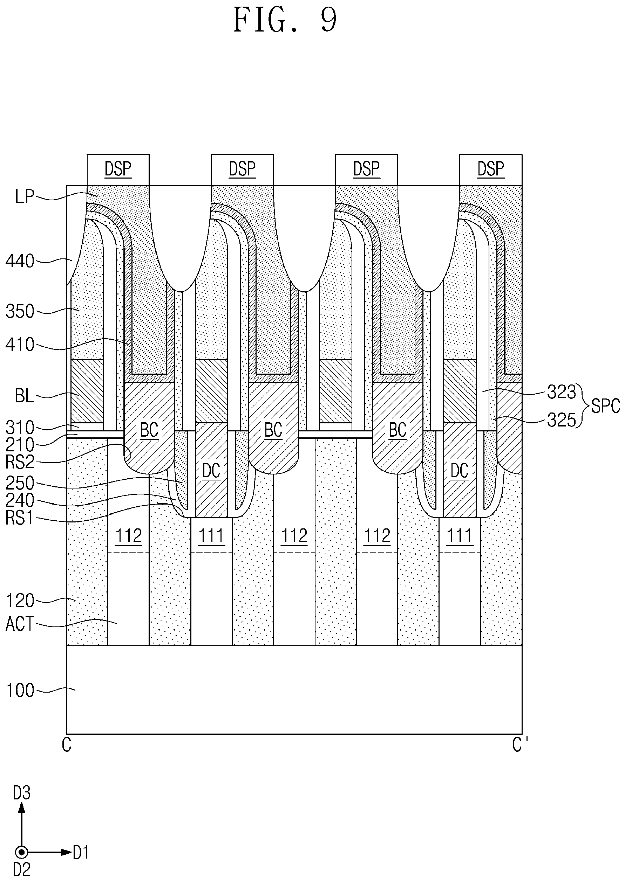

FIG. 7 is an enlarged view of a portion `PC' of FIG. 2. FIGS. 8 and 9 are sectional views, which are respectively taken along lines B-B' and C-C' of FIG. 7. Hereinafter, an example, in which a semiconductor device including a data storage pattern is provided on the chip region, will be described with reference to FIGS. 7 to 9, but example embodiments are not limited to a data storage pattern.

Referring to FIGS. 7 to 9, a device isolation pattern 120 may be disposed in the chip region 10 of the substrate 100 of FIG. 2 to define active patterns ACT. The active patterns ACT may be disposed to be spaced apart from each other in the first and second directions D1 and D2.

The active patterns ACT may be isolated bar-shaped patterns or islands, which are spaced apart from each other and are elongated in a fourth direction D4. When viewed in a plan view, the active patterns ACT may be portions of the substrate 100 enclosed by the device isolation pattern 120. As an example, the active patterns ACT may be portions of the substrate 100 protruding in the third direction D3. The device isolation pattern 120 may be formed of or include at least one of insulating materials (e.g., silicon oxide, silicon nitride, or combinations thereof), and may be a shallow trench isolation (STI) layer. In some example embodiments, the lower pattern layer 102 of FIG. 6 may be formed of or include the same material as the active patterns ACT and/or the device isolation pattern 120. As an example, the lower key pattern LK of FIGS. 3B and 3C may include a key pattern, which is used to monitor alignment of the active patterns ACT, but example embodiments are not limited to this example.

First impurity regions 111 and second impurity regions 112 may be provided in the active patterns ACT. The second impurity regions 112 may be provided in opposite edge regions of each active pattern ACT. Each of the first impurity regions 111 may be interposed between the second impurity regions 112 in each active pattern ACT. The first impurity regions 111 may include impurities that are of the same conductivity type (e.g., an n-type) as the second impurity regions 112, and/or may include other impurities such as p-type impurities and/or carbon and/or germanium; however, example embodiments are not limited thereto..

A conductive line such as a word line WL may be provided in the active patterns ACT. In some example embodiments, a plurality of word lines WL may be provided. The word lines WL may be extended in the first direction D1 and may be spaced apart from each other in the second direction D2. The word lines WL may be disposed in trenches, which are formed in the active patterns ACT and the device isolation pattern 120. In some example embodiments, a pair of the word lines WL, which are adjacent to each other in the second direction D2, may be provided to cross the active patterns ACT.

Each of the word lines WL may include a gate electrode GE, a gate dielectric pattern GI, and a gate capping pattern GC. The gate electrode GE may be provided to penetrate the active patterns ACT and the device isolation pattern 120 along the first direction D1. The gate dielectric pattern GI may be interposed between the gate electrode GE and the active patterns ACT and between the gate electrode GE and the device isolation pattern 120. The gate capping pattern GC may be provided on the gate electrode GE to cover the gate electrode GE.

As an example, a bottom surface of the word line WL may be located at substantially the same level as a bottom surface of the key pattern layer KPL (e.g., a bottom surface of the third key pattern K3), but example embodiments are not limited to this example. The fine key pattern FP of FIG. 4 may be formed of or include the same material as, e.g. may be formed at the same time as, at least a portion of the word line WL. As an example, the third key pattern K3 of the fine key pattern FP may be formed of or include the same material as at least a portion of the word line WL. As another example, the third key pattern K3 of the fine key pattern FP may further include a material, which is not included in the word line WL.

The word lines WL may be provided to have a second pitch P2 in the second direction D2As used herein, the second pitch P2 of the word lines WL may be defined as a width of unit areas, each of which includes four word lines WL arranged in the second direction D2. The second pitch P2 may be smaller than the first pitch P1 of FIG. 4. As an example, a difference between the first and second pitches P1 and P2 in the example of FIG. 4 may range from 4 nm to 10 nm.

Each pair of the word lines WL adjacent to each other may be spaced apart from each other in the second direction D2. Here, a distance between the pair of the word lines WL in the second direction D2 may be defined as a sixth width W6. In some example embodiments, the sixth width W6 may be substantially equal to the first and second widths W1 and W2 of FIG. 4. The sixth width W6 may be smaller than each of the third and fourth widths W3 and W4 of FIG. 4. As an example, a value, which is obtained by subtracting the sixth width W6 from each of the third and fourth widths W3 and W4, may be larger than 0 nm and may be equal to or smaller than 10 nm.

Each of the word lines WL may have a width in the second direction D2. The width of each of the word lines WL may be defined as a seventh width W7. The seventh width W7 may be substantially equal to the fifth width W5 of FIG. 4.

A buffer pattern 210 may be disposed on the substrate 100. The buffer pattern 210 may cover the active patterns ACT, the device isolation pattern 120, and the word lines WL. In some example embodiments, the buffer pattern 210 may be formed of or include at least one of silicon oxide, silicon nitride, silicon oxynitride, or combinations thereof.

A bit line BL may be provided on the device isolation pattern 120 and the active patterns ACT. In some example embodiments, a plurality of bit lines BL may be provided. The bit lines BL may be extended in the second direction D2 and may be spaced apart from each other in the first direction D1. The bit line BL may be formed of or include at least one of metallic materials. As an example, the bit line BL may be formed of or include at least one of tungsten, rubidium, molybdenum, titanium, or combinations thereof. As an example, the upper key pattern UK of FIGS. 3B and 3C may include a key pattern, which is used to monitor alignment of the bit line BL, but example embodiments are not limited to this example.

In some example embodiments, a plurality of bit line contacts DC may be provided on the active patterns ACT, respectively. The bit line contacts DC may be respectively connected to the first impurity regions 111 in the active patterns ACT. The bit line contacts DC may be spaced apart from each other in the first and second directions D1 and D2. The bit line contacts DC may be respectively interposed between the active patterns ACT and the bit lines BL. Each of the bit line contacts DC may electrically connect a corresponding pair of the bit line BL and the first impurity region 111 to each other.

The bit line contacts DC may be disposed in first recess regions RS1, respectively. The first recess regions RS1 may be provided in upper portions of the active patterns ACT and the device isolation pattern 120, which are adjacent to each other. The first recess regions RS1 may be spaced apart from each other in the first and second directions D1 and D2.

A polysilicon pattern 310 may be provided between the bit line BL and the buffer pattern 210 and between the bit line contacts DC, which are adjacent to each other in the second direction D2. In some example embodiments, a plurality of polysilicon patterns 310 may be provided. The polysilicon pattern 310 may have a top surface that is located at substantially the same height as (i.e., coplanar with) the top surface of the bit line contact DC. The polysilicon pattern 310 may be formed of or include polysilicon, and may or may not be doped with impurities.

Although not shown, as an example, a first barrier pattern may be provided between the bit line BL and the bit line contact DC and between the bit line BL and the polysilicon pattern 310. The first barrier patterns may be formed of or include at least one of conductive metal nitride materials (e.g., tungsten nitride, rubidium nitride, molybdenum nitride, titanium nitride, or combinations thereof). A first ohmic pattern (not shown) may be further interposed between the first barrier pattern and the bit line contact DC. The first ohmic pattern may be formed of or include at least one of metal silicide materials.

A bit line capping pattern 350 may be provided on a top surface of the bit line BL. In some example embodiments, a plurality of bit line capping patterns 350 may be provided. The bit line capping patterns 350 may be extended in the second direction D2 or along respective ones of the bit lines BL and may be spaced apart from each other in the first direction D1. The bit line capping pattern 350 may be vertically overlapped with the bit line BL. The bit line capping pattern 350 may be composed of a single layer or a plurality of layers. The bit line capping pattern 350 may be formed of or include silicon nitride.

A bit line spacer SPC may be provided on a side surface of the bit line BL and a side surface of the bit line capping pattern 350. The bit line spacer SPC may cover the side surface of the bit line BL and the side surface of the bit line capping pattern 350. In some example embodiments, a plurality of bit line spacers SPC may be provided.

In some example embodiments, the bit line spacer SPC may include a first bit line spacer 323 and a second bit line spacer 325. The second bit line spacer 325 may be provided on the side surface of the bit line BL, and the first bit line spacer 323 may be interposed between the side surface of the bit line BL and the second bit line spacer 325. In some example embodiments, the second bit line spacer 325 may cover a top surface of the bit line capping pattern 350. As an example, the first bit line spacer 323 may be formed of or include silicon oxide, and the second bit line spacer 325 may be formed of or include silicon nitride. As another example, the first bit line spacer 323 may include an empty space (i.e., an air gap) with an air layer. In some example embodiments, although not shown, a third bit line spacer or a side capping pattern may be further interposed between the side surface of the bit line BL and the first bit line spacer 323.

A first gapfill pattern 240 and a second gapfill pattern 250 may be provided to fill each of the first recess regions RS1. The first gapfill pattern 240 may be provided to conformally cover an inner surface of the first recess region RS1 and at least a portion of a side surface of the bit line contact DC (e.g., at least a portion of a side surface of the bit line contact DC in the first recess region RS1). The second gapfill pattern 250 may fill a remaining portion of the first recess region RS1. As an example, the first gapfill pattern 240 may be formed of or include silicon oxide, and the second gapfill pattern 250 may be formed of or include silicon nitride.

A storage node contact BC may be provided between adjacent ones of the bit lines BL. In some example embodiments, a plurality of storage node contacts BC may be provided, and in this case, the storage node contacts BC may be spaced apart from each other in the first and second directions D1 and D2. Although not shown, the storage node contacts BC may be spaced apart from each other, in the second direction D2, by fence patterns (not shown) on the word lines WL. In some example embodiments, the fence patterns may be formed of or include silicon nitride.

The storage node contact BC may fill a second recess region RS2, which is provided in the active pattern ACT and on the second impurity region 112. The storage node contact BC may be electrically connected to the second impurity region 112. The storage node contact BC may be formed of or include at least one of doped or undoped polysilicon, metallic materials, or combinations thereof.

A second barrier pattern 410 may be provided to conformally cover the bit line spacer SPC and the storage node contact BC. The second barrier pattern 410 may be formed of or include at least one of metal nitride materials (e.g., titanium nitride and tantalum nitride). A second ohmic pattern (not shown) may be further interposed between the second barrier pattern 410 and the storage node contact BC. The second ohmic pattern may be formed of or include a metal silicide material.

A landing pad LP may be provided on the storage node contact BC. In some example embodiments, a plurality of landing pads LP may be provided, and here, the landing pads LP may be spaced apart from each other in the first and second directions D1 and D2. Each of the landing pad LP may be electrically connected to a corresponding one of the storage node contacts BC. The landing pad LP may cover a top surface of the bit line capping pattern 350. An upper portion of the landing pad LP may be shifted from the storage node contact BC in the first direction D1. The landing pad LP may be formed of or include at least one of metallic materials (e.g., one or more of tungsten, titanium, and tantalum).

A filling pattern 440 may be provided to enclose the landing pad LP. The filling pattern 440 may be interposed between adjacent ones of the landing pads LP. When viewed in a plan view, the filling pattern 440 may be provided in a mesh shape with holes, and in this case, the landing pads LP may be provided in the holes to penetrate the filling pattern 440. As an example, the filling pattern 440 may be formed of or include at least one of silicon nitride, silicon oxide, silicon oxynitride, or combinations thereof. As another example, the filling pattern 440 may include an empty space (i.e., an air gap) with an air layer.

A data storage pattern DSP may be provided on the landing pad LP. In some example embodiments, a plurality of data storage patterns DSP may be provided, and the data storage patterns DSP may be spaced apart from each other in the first and second directions D1 and D2. The data storage patterns DSP may be respectively connected to the second impurity regions 112 through the landing pads LP and the storage node contacts BC.

In some example embodiments, the data storage pattern DSP may be a capacitor including a bottom electrode, a dielectric layer, and a top electrode. In this case, the semiconductor memory device according to some example embodiments may be or may include a dynamic random access memory (DRAM) device. Alternatively or additionally, the data storage pattern DSP may include a magnetic tunnel junction pattern. In this case, the semiconductor memory device may be or may include a magnetic random access memory (MRAM) device. Alternatively or additionally, the data storage pattern DSP may be formed of or include a phase-change material or a variable resistance material. In this case, the semiconductor memory device may be or may include a phase-change random access memory (PRAM) device and/or a resistive random access memory (ReRAM) device. However, example embodiments are not limited to these examples, and the data storage pattern DSP may include various structures and/or materials which can be used to store data.

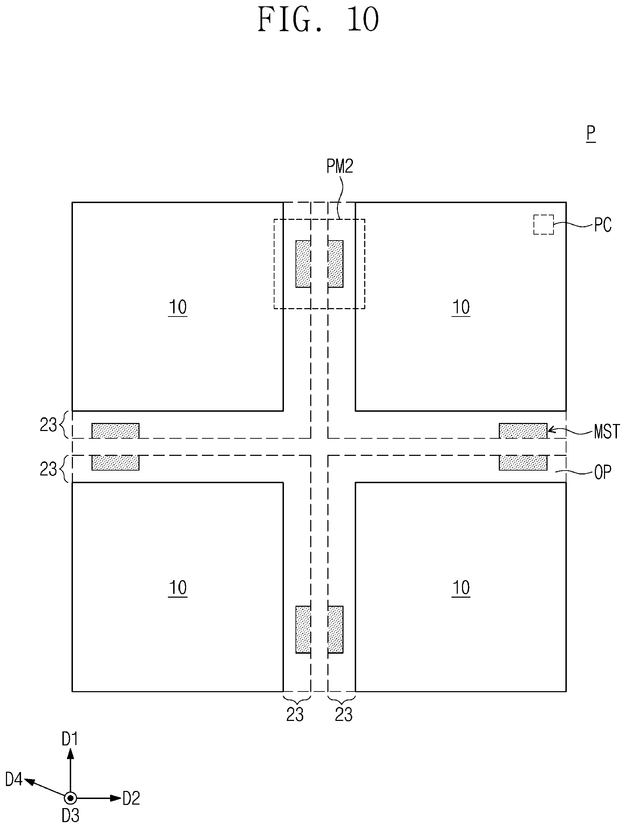

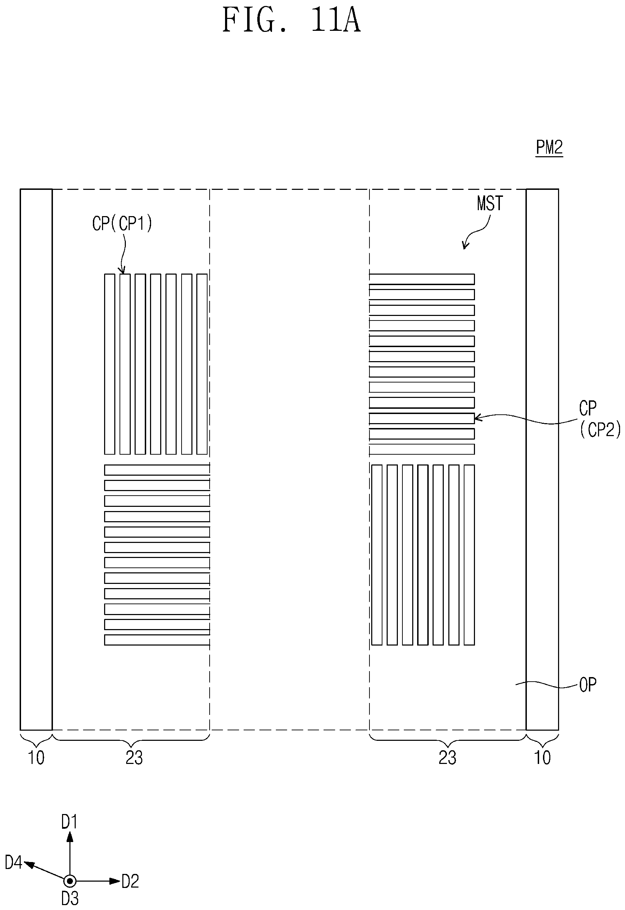

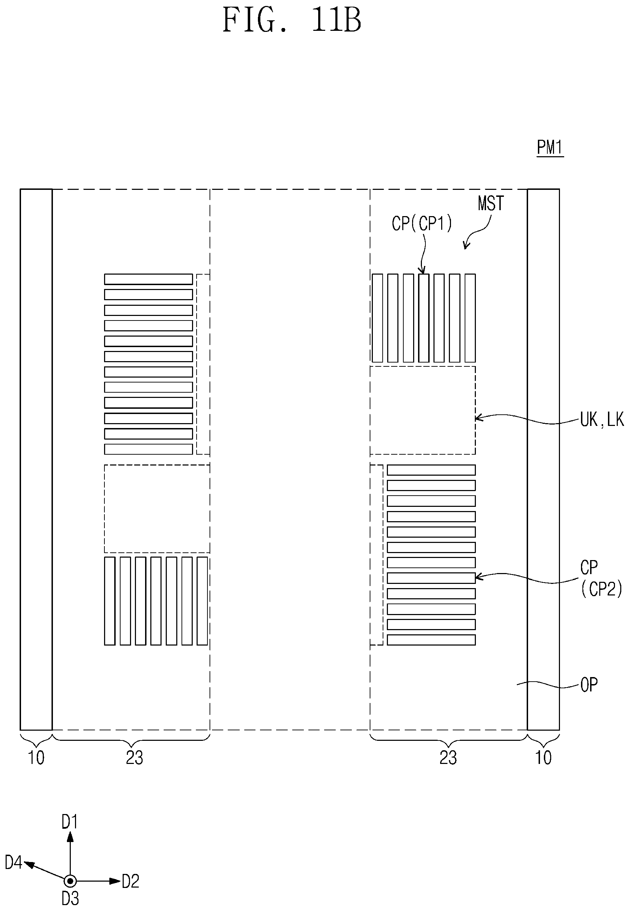

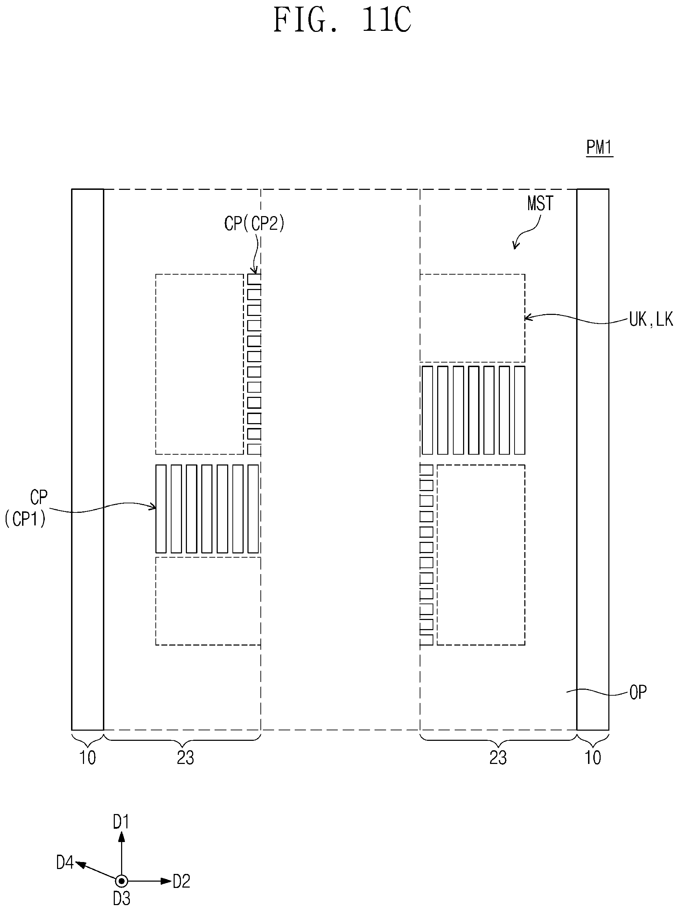

FIG. 10 is an enlarged view illustrating a portion 'P' of FIG. 1. FIGS. 11A to 11C are enlarged views illustrating a portion 'PM2' of FIG. 10. A structure of the process-monitoring structure after a cutting process of separating the chip regions from each other will be described in more detail with reference to FIGS. 10 to 11C. For concise description, a previously described element may be identified by the same reference number without repeating an overlapping description thereof.

Referring to FIGS. 10 to 11C, a cutting process may be performed on the cutting region 21 of the scribe lane region 20 to separate the chip regions 10 from each other. After the cutting process, the chip regions 10 may be enclosed by the edge regions 23, respectively, and a portion of the process-monitoring structure MST may be left on the edge region 23.

FIGS. 11A to 11C illustrate the shapes of the chip regions 10 and the process-monitoring structure MST of FIGS. 3A to 3C, respectively, after the cutting step. The coarse key patterns CP of the process-monitoring structure MST may be left on the edge regions 23. Each of the coarse key patterns CP may be configured to have substantially the same features as that in various example embodiments described with reference to FIGS. 4 to 6. For example, the geometrical features of the fine key patterns FP (e.g., the first pitch P1 and the first to fifth widths W1, W2, W3, W4, and W5) may be substantially the same as those in the embodiment described with reference to FIGS. 4 to 6. As an example, in the case where the data storage pattern DSP is provided on the chip region 10, a structure on the chip region 10 may have substantially the same features as that in the embodiment described with reference to FIGS. 7 to 9.

As used herein, the cutting region 21 of the scribe lane region 20 is illustrated to be linearly extended in the first and second directions D 1 and D2, but example embodiments are not limited to this example. For example, the cutting region 21 may be extended in a direction crossing the first and second directions D1 and D2 or may be extended to have an uneven profile, when viewed in a plan view.

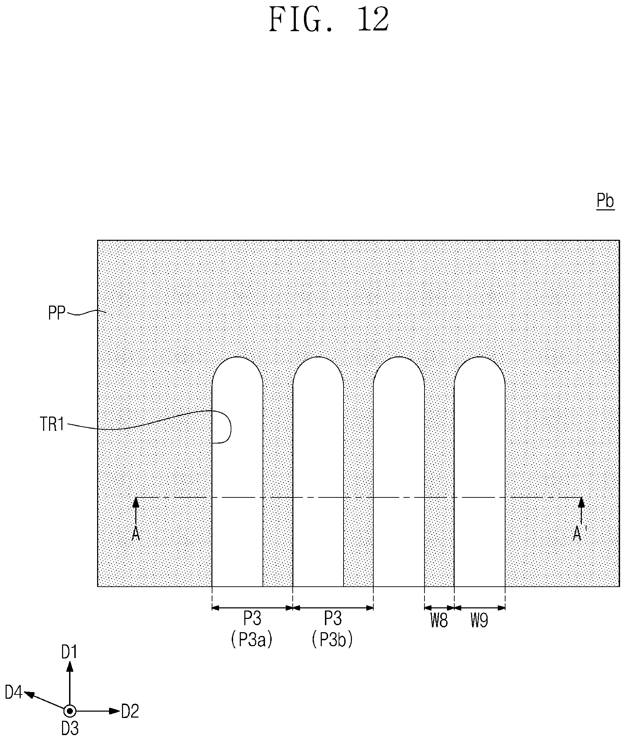

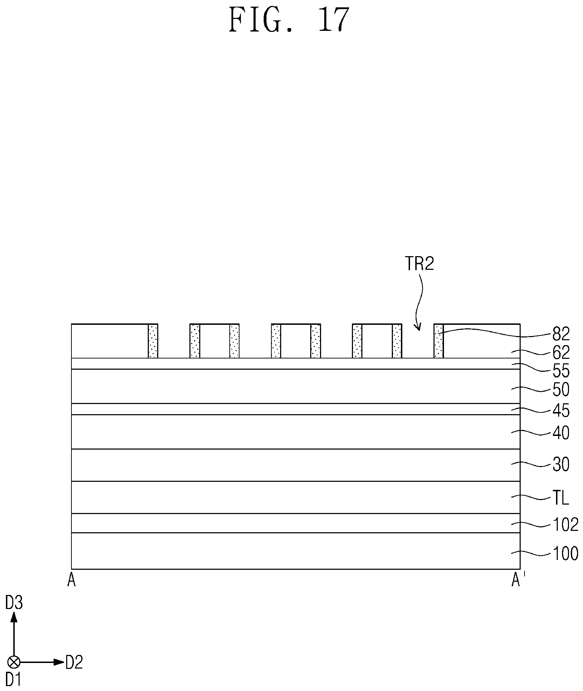

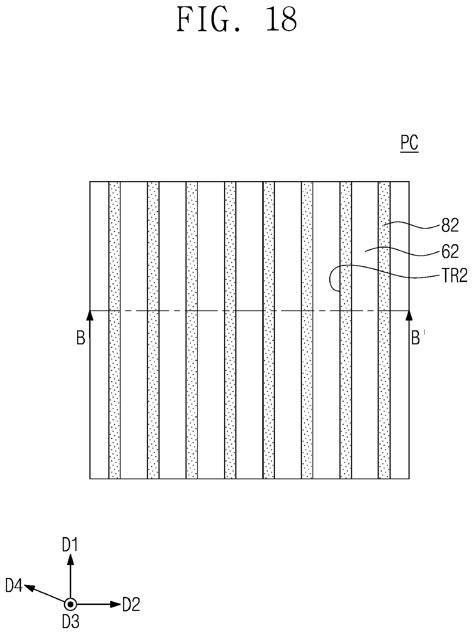

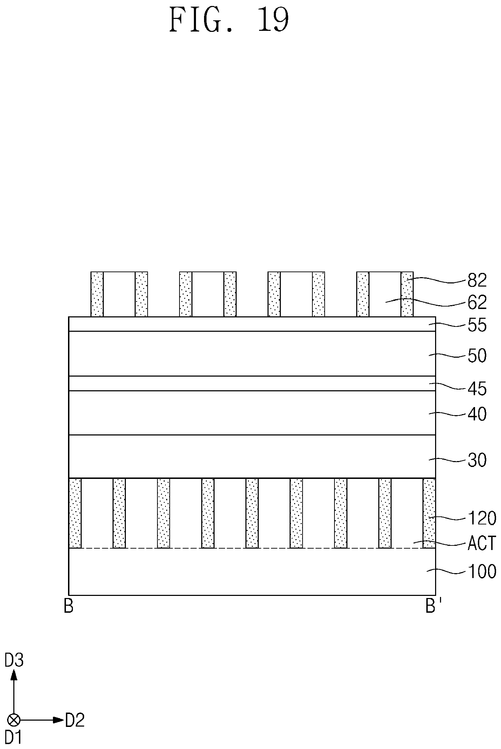

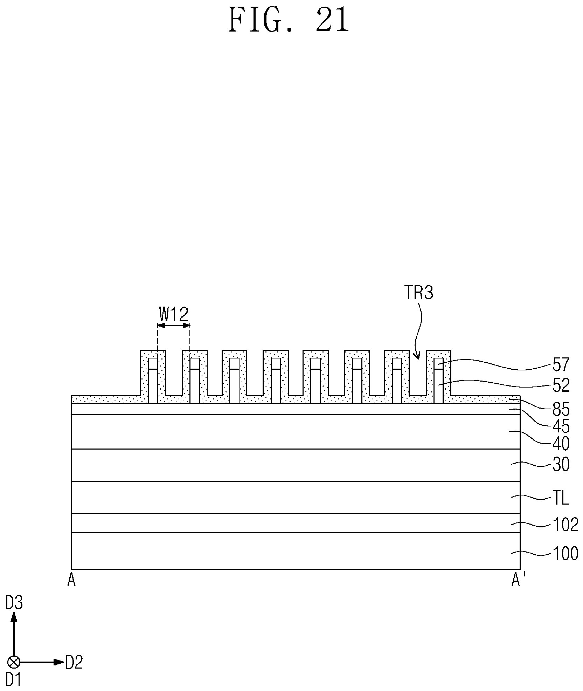

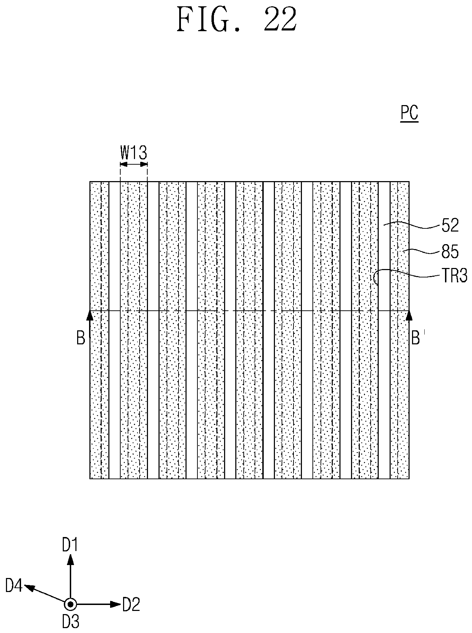

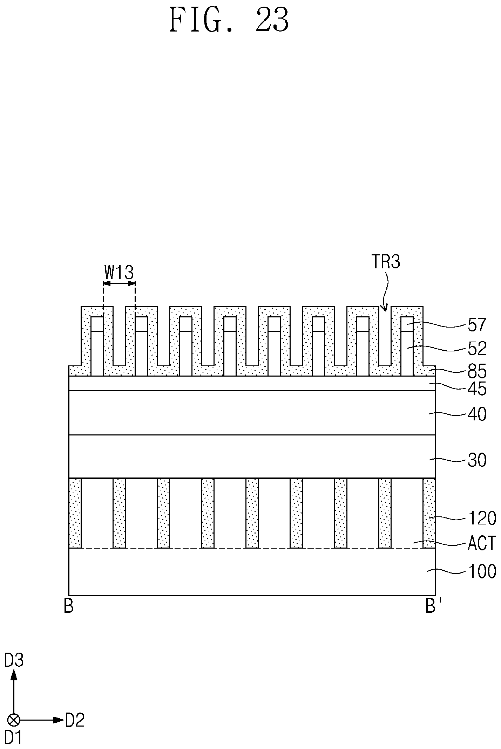

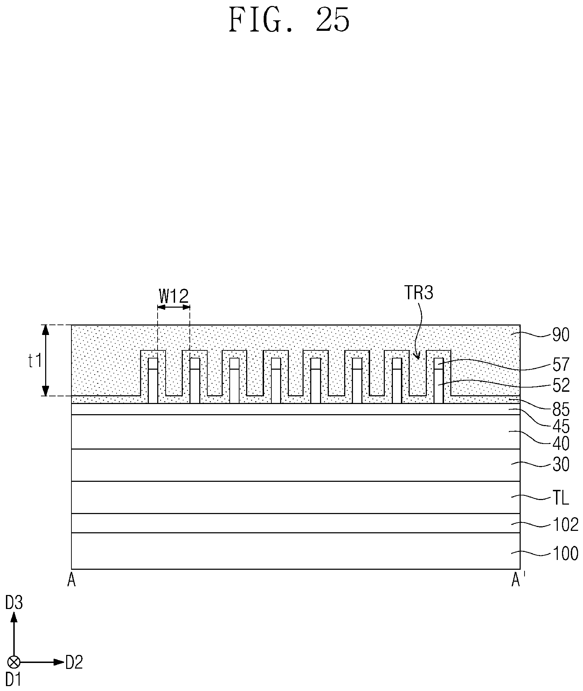

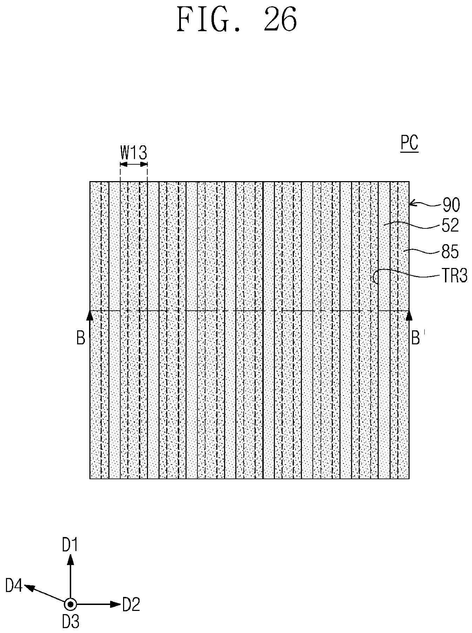

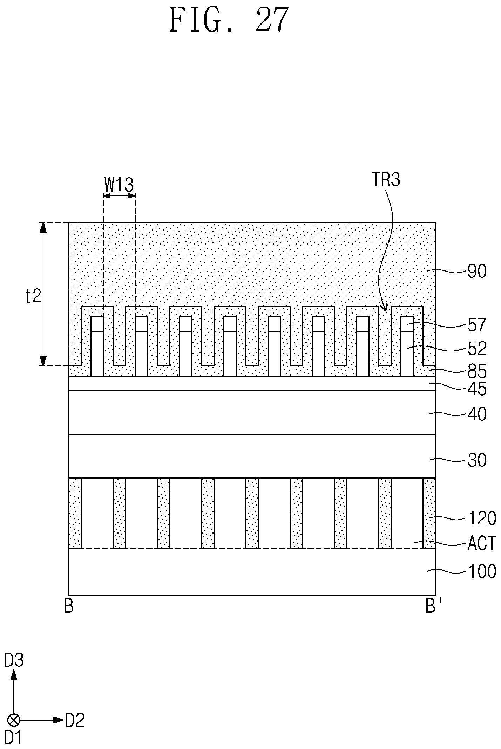

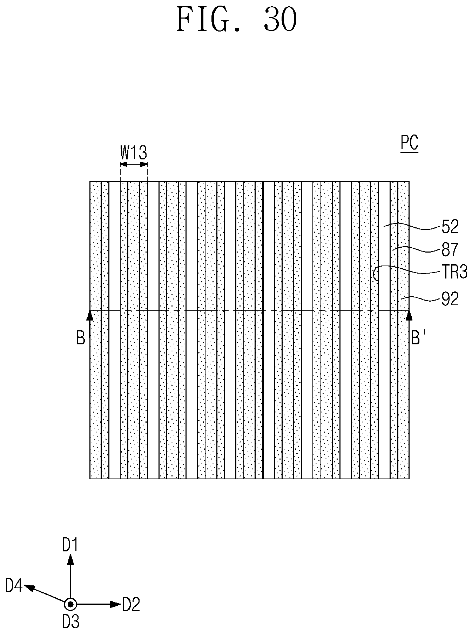

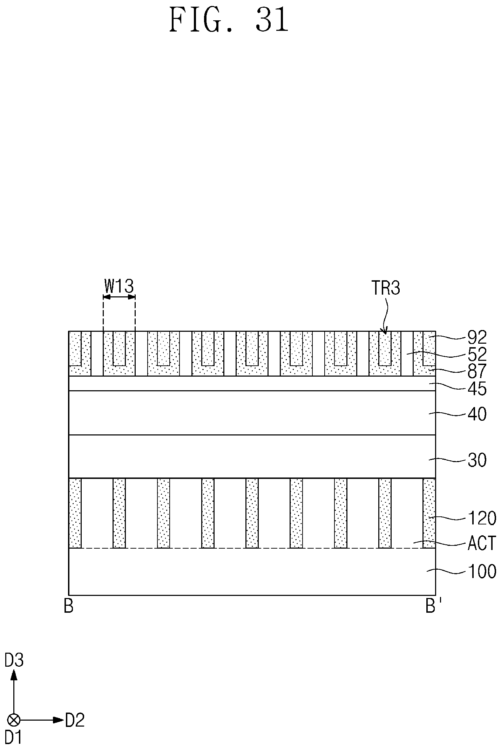

FIGS. 12 to 35 are diagrams illustrating a method of fabricating a semiconductor device, according to some example embodiments. Hereinafter, a method of fabricating a semiconductor device according to some example embodiments will be described in more detail with reference to FIGS. 12 to 35. For concise description, a previously described element may be identified by the same reference number without repeating an overlapping description thereof.

Referring to FIGS. 12 to 15, the substrate 100 including the chip regions 10 and the scribe lane region 20 may be provided. The device isolation pattern 120 and the active patterns ACT may be formed in the chip regions 10 of the substrate 100. The formation of the device isolation pattern 120 and the active patterns ACT may include forming grooves in the substrate 100 through a patterning process and filling the grooves with an insulating material to form the device isolation pattern 120. The active patterns ACT may include portions of the substrate 100, in which the grooves are not formed. The lower pattern layer 102 and a target layer TL may be formed on the scribe lane region 20 during, before or after the formation of the device isolation pattern 120 and the active patterns ACT. The target layer TL may be formed on the lower pattern layer 102.

A plurality of mask layers may be formed on the substrate 100. The formation of the mask layers may include sequentially forming a lower mask layer 30, a first mask layer 40, a second mask layer 50, a third mask layer 60, an upper mask layer 70, and a photoresist pattern PP on the substrate 100. On the scribe lane region 20, the lower mask layer 30 may be formed on the target layer TL. On the chip region 10, the lower mask layer 30 may be formed on the device isolation pattern 120 and the active patterns ACT. In addition, a first auxiliary mask layer 45 may be further formed between the first mask layer 40 and the second mask layer 50, a second auxiliary mask layer 55 may be further formed between the second mask layer 50 and the third mask layer 60, and a third auxiliary mask layer 65 may be further formed between the third mask layer 60 and the upper mask layer 70.

In some example embodiments, the lower mask layer 30 may be formed of or include silicon oxide. In some example embodiments, the first to third mask layers 40, 50, and 60 and the upper mask layer 70 may be formed of or include at least one of carbon-based materials (e.g., amorphous carbon layer (ACL) and spin-on hardmask (SOH)). As an example, each of the first to third auxiliary mask layers 45, 55, and 65 may be formed of or include a material having an etch selectivity with respect to the first to third mask layers 40, 50, and 60. In the case where the first to third mask layers 40, 50, and 60 are formed of carbon-based materials, the first to third auxiliary mask layers 45, 55, and 65 may be formed of or include at least one of silicon oxide, silicon nitride, silicon oxynitride, or combinations thereof. However, example embodiments are not limited to these examples, and the materials stated above may be changed to various materials that can be considered by a person skilled in the art.

The photoresist pattern PP may include first trenches TR1, which are extended in the first direction D1. The first trenches TR1 may be spaced apart from each other in the second direction D2. A width of each of the first trenches TR1 in the second direction D2 may decrease in a downward direction. Alternatively or additionally, the outermost one of the first trenches TR1 in the second direction D2 may have a steeply-decreasing width in the downward direction, compared with others of the first trenches TR1.

Thus, each of widths and pitches to be described below (e.g., eighth to eleventh widths W8, W9, W10, and W11 and third and fourth pitches P3 and P4) may be defined as an average value, such as a mean or median or mode value of widths or pitches measured between a first level LV1 to a second level LV2. Here, the first and second levels LV1 and LV2 may be located at different levels. In addition, the average value of the width or pitch may be an average value of widths or pitches measured at several points between the first to second levels LV1 and LV2. As an example, the first level LV1 may be a level corresponding to 15% of a total height of the photoresist pattern PP from the bottom of the photoresist pattern PP. The second level LV1 may be a level corresponding to 15% of the total height of the photoresist pattern PP from the top of the photoresist pattern PP (i.e., 85% from the bottom).

The eighth to eleventh widths W8, W9, W10, and W11 and the third and fourth pitches P3 and P4 may also be used in a process-monitoring step. As an example, each of the eighth to eleventh widths W8, W9, W10, and W11 and the third and fourth pitches P3 and P4 may be used to examine an alignment state of a pattern in an exposure process or to measure a linewidth of a pattern. Since the mean value of the widths or pitches measured at several levels is used for the process-monitoring step, it may be possible to control and manage a variation in process characteristics between the outermost one of the first trenches TR1 and the others of the first trenches TR1 in a more accurate manner. As a result, the fabrication process may be easily controlled and managed, and furthermore, a failure in the fabrication process may be reduced.

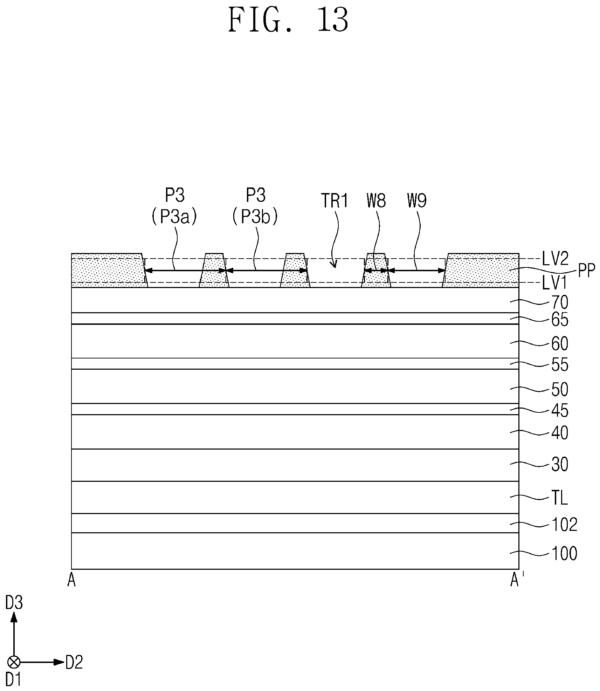

On the scribe lane region 20, a distance between the first trenches TR1, which are adjacent to each other in the second direction D2, may be defined as the eighth width W8, as shown in FIGS. 12 and 13. A width of each of the first trenches TR1 in the second direction D2 may be defined as the ninth width W9. The photoresist pattern PP may have the third pitch P3. The third pitch P3 may be defined as a width of each of unit regions, which are repeated in the second direction D2 on the scribe lane region 20 and each of which includes one first trench TR1. The third pitch P3 may be substantially equal to a sum of the eighth and ninth widths W8 and W9.

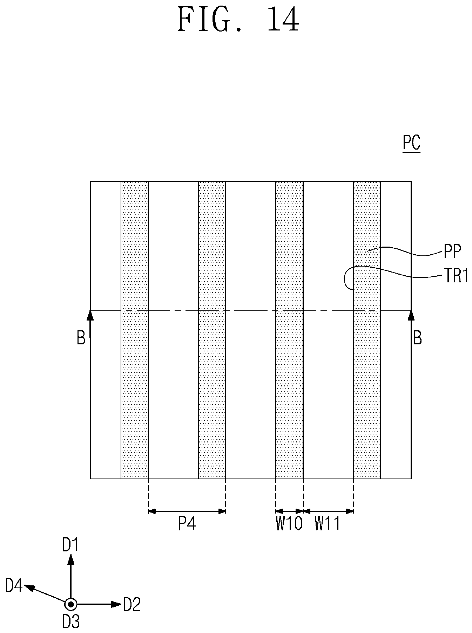

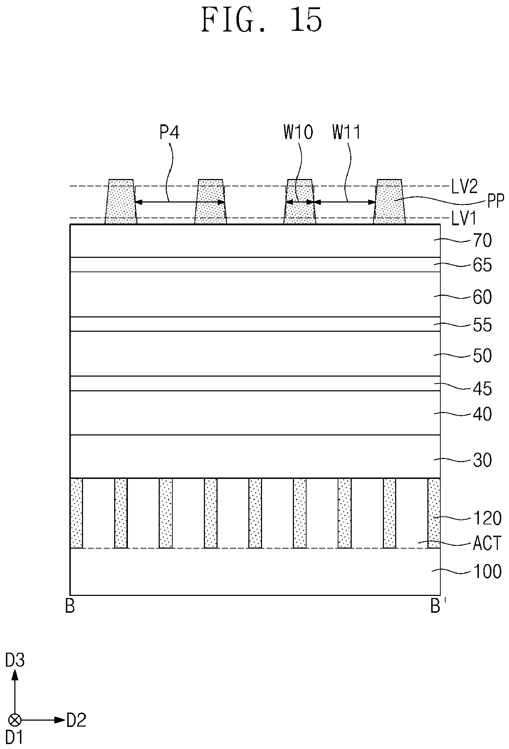

On the chip region 10, a distance between the first trenches TR1, which are adjacent to each other in the second direction D2, may be defined as the tenth width W10, as shown in FIGS. 14 and 15. A width of each of the first trenches TR1 in the second direction D2 may be defined as the eleventh width W11. The photoresist pattern PP may have the fourth pitch P4. The fourth pitch P4 may be defined as a width of each of unit regions, which are repeated in the second direction D2 on the chip region 10 and each of which includes one first trench TR1. The fourth pitch P4 may be substantially equal to a sum of the tenth and eleventh widths W10 and W11.

The eighth width W8 may be substantially equal to or different from the tenth width W10. The ninth width W9 may be substantially equal to or different from the eleventh width W11. In the case where the eighth width W8 is substantially equal to the tenth width W10, the ninth width W9 may be different from the eleventh width W11. In the case where the ninth width W9 is substantially equal to the eleventh width W11, the eighth width W8 may be different from the tenth width W10. In some example embodiments, the eighth and tenth widths W8 and W10 may be different from each other, and the ninth and eleventh widths W9 and W11 may be different from each other. A sum of the eighth and ninth widths W8 and W9 may be larger than a sum of the tenth and eleventh widths W10 and W11. In other words, the third pitch P3 may be larger than the fourth pitch P4. As an example, a difference between the third pitch P3 and the fourth pitch P4 may range from 4 nm to 10 nm.

The third pitch P3 may include a first sub-pitch P3a and a second sub-pitch P3b. The first sub-pitch P3a may be a pitch of a region, which includes the outermost one of the first trenches TR1 in the second direction D2. The second sub-pitch P3b may be a pitch of a region, which includes the first trench TR1 located between the outmost ones of the first trenches TR1. The first sub-pitch P3a may be different from the second sub-pitch P3b. As an example, the first sub-pitch P3a may be larger or smaller than the second sub-pitch P3b. Thus, the first pitch P1a of the first fine key pattern FPa of FIG. 4 may be different from the first pitch P1b of the second fine key pattern FPb.

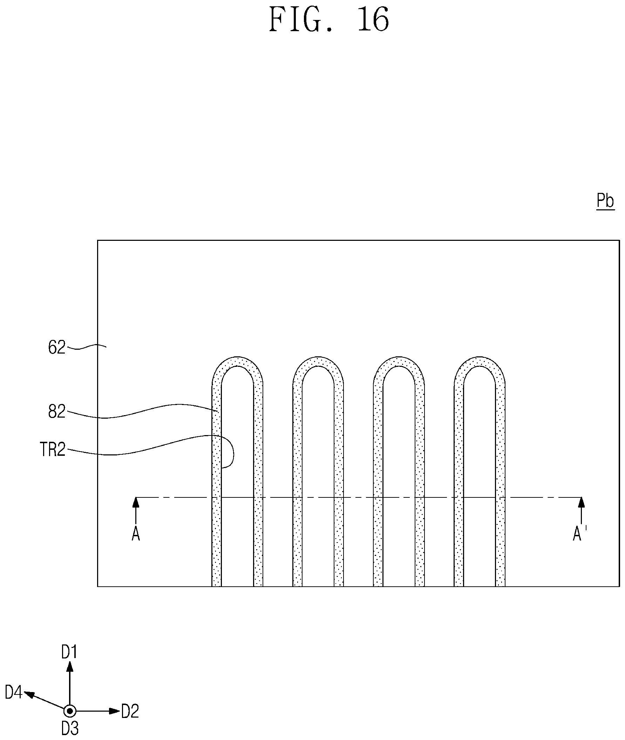

Referring to FIGS. 16 to 19, a third mask pattern 62 and a third auxiliary mask pattern (not shown) may be formed by patterning the third mask layer 60 and the third auxiliary mask layer 65 using the photoresist pattern PP. The formation of the third mask pattern 62 and the third auxiliary mask pattern may include patterning the upper mask layer 70 using the photoresist pattern PP to form an upper mask pattern (not shown) and etching the third mask layer 60 and the third auxiliary mask layer 65 using the upper mask pattern as an etch mask. In this case, the third mask pattern 62 may have second trenches TR2, which are formed in regions vertically overlapping the first trenches TR1 of the photoresist pattern PP. Each of the second trench TR2 may be formed to expose a portion of the second auxiliary mask layer 55 to the outside.

A first spacer layer (not shown) may be formed to conformally cover the third mask pattern 62, the third auxiliary mask pattern, and the exposed portion of the second auxiliary mask layer 55. In detail, the first spacer layer may conformally cover a top surface of the third auxiliary mask pattern and inner surfaces of the second trenches TR2. In some example embodiments, the first spacer layer may be formed of or include silicon oxide, but example embodiments are not limited to this example. Thereafter, first spacers 82 may be formed by partially removing the first spacer layer. The partial removal of the first spacer layer may include removing the first spacer layer on the top surface of the third auxiliary mask pattern and the exposed portion of the second auxiliary mask layer 55, and the third auxiliary mask pattern may be further removed. As a result, the first spacers 82 may cover inner side surfaces of the second trenches TR2 (i.e., side surfaces of the third mask pattern 62).

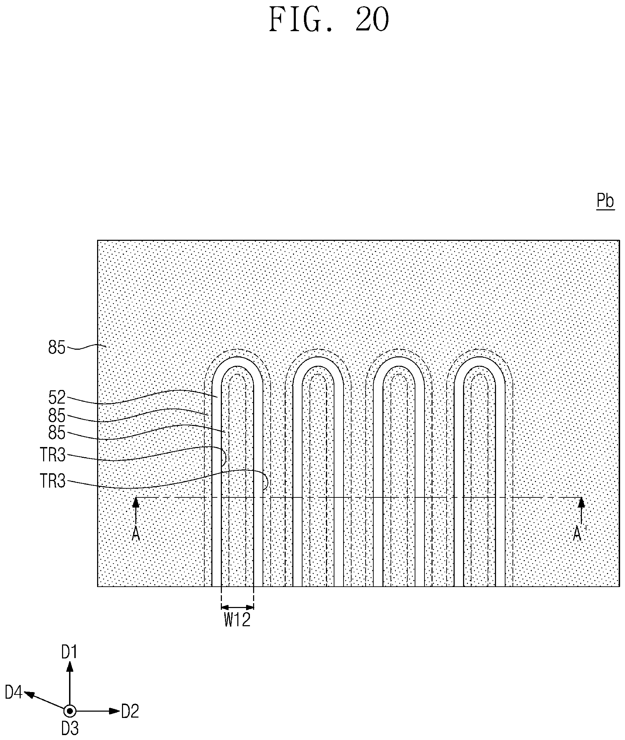

Referring to FIGS. 20 to 23, the third mask pattern 62 may be removed, and the second auxiliary mask layer 55 and the second mask layer 50 may be etched using the first spacers 82 as an etch mask. A second auxiliary mask pattern 57 and a second mask pattern 52 may be respectively formed by the etching of the second auxiliary mask layer 55 and the second mask layer 50. The second mask pattern 52 may have third trenches TR3 in regions that are overlapped with the second trenches TR2 and the third mask pattern 62. The third trenches TR3 may be formed to expose the first auxiliary mask layer 45 to the outside.

Thereafter, a second spacer layer 85 may be formed to conformally cover the second mask pattern 52, the second auxiliary mask pattern 57, and the exposed portions of the first auxiliary mask layer 45. In detail, the second spacer layer 85 may conformally cover a top surface of the second auxiliary mask pattern 57 and inner surfaces of the third trenches TR3. In some example embodiments, the second spacer layer 85 may be formed of or include silicon oxide, but example embodiments are not limited to this example. When measured in the second direction D2, a width W12 of each of the third trenches TR3 on the scribe lane region 20 may be larger than a width W13 of each of the third trenches TR3 on the chip region 10.

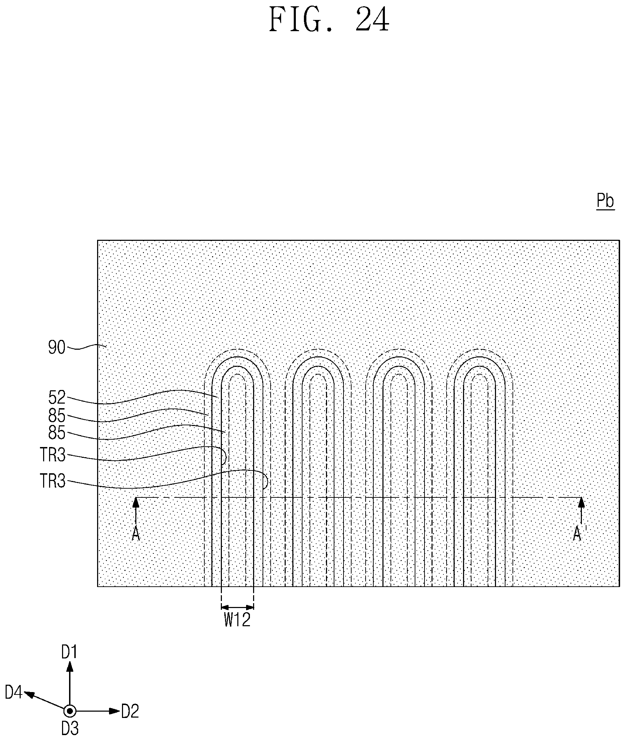

Referring to FIGS. 24 to 27, an additional mask layer 90 may be formed to cover the entire top surface of the substrate 100. The additional mask layer 90 may be formed to fill the third trenches TR3 and to cover a top surface of the second mask pattern 52. The additional mask layer 90 may be formed on the substrate 100 using a spin coating method. In some example embodiments, the additional mask layer 90 may be formed of or include at least one of carbon-containing materials.

A pattern density in the scribe lane region 20 may be different from that in the chip region 10. Thus, the additional mask layer 90 may have different thicknesses on the scribe lane region 20 and the chip region 10, when measured in the third direction D3. For example, a first thickness t1 of the additional mask layer 90 on the scribe lane region 20 may be different from a second thickness t2 of the additional mask layer 90 on the chip region 10. As an example, the first thickness t1 may be smaller than the second thickness t2. The difference between the second thickness t2 and the first thickness t1 may range from 20 nm to 30 nm.

An additional mask pattern 92, which is formed from the additional mask layer 90, may be used as an etch mask in a process of etching the first mask layer 40 to be described below. Here, due to the thickness difference of the additional mask layer 90, a first mask pattern 42 on the scribe lane region 20 may be further etched than the first mask pattern 42 on the chip region 10. However, according to some example embodiments, the third pitch P3 of FIG. 12 may be larger than the fourth pitch P4 of FIG. 14, and thus, a first mask key pattern 42a and an inner mask key pattern 42i of the first mask pattern 42 may be formed to have widths that are relatively larger than the first mask pattern 42 on the chip region 10. Accordingly, although the first mask layer 40 on the scribe lane region 20 is more strongly affected by the etching process than that on the chip region 10, the first mask pattern 42 may be easily formed. As a result, it may be possible to easily form the first and second key patterns K1 and K2 of FIG. 4 and to reduce a process failure.

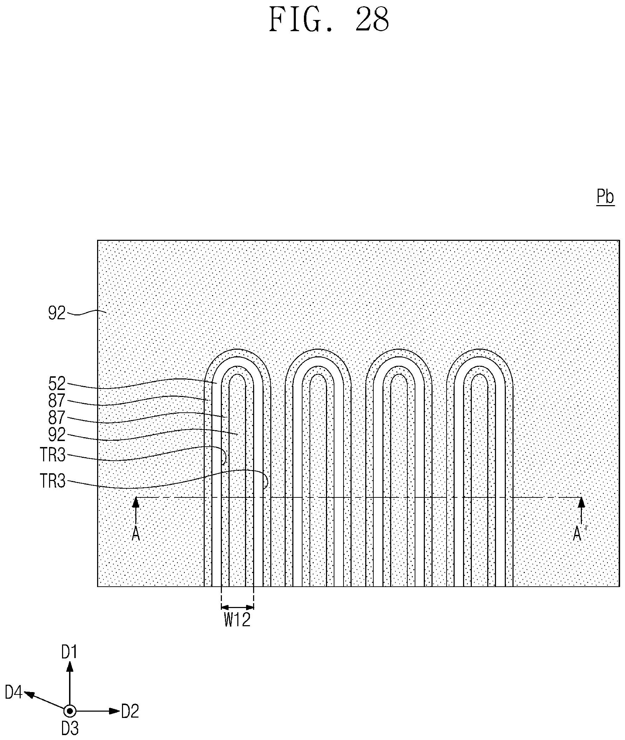

Referring to FIGS. 28 to 31, additional mask patterns 92 and second spacers 87 may be respectively formed by removing an upper portion of the additional mask layer 90 and an upper portion of the second spacer layer 85. Here, the second auxiliary mask pattern 57 may be further removed. The second spacers 87 may conformally cover inner surfaces of the third trenches TR3, and the additional mask patterns 92 may fill remaining portions of the third trenches TR3. The second spacers 87, which are placed on side surfaces of the second mask pattern 52 may have substantially the same thickness in the second direction D2. The second mask pattern 52 may be interposed between the second spacers 87. A width of the second mask pattern 52 in the second direction D2 may be smaller than a width of each of the additional mask patterns 92 in the third trenches TR3. The additional mask patterns 92 in the third trenches TR3, which are adjacent to each other in the second direction D2, may have substantially the same width or may have different widths from each other.

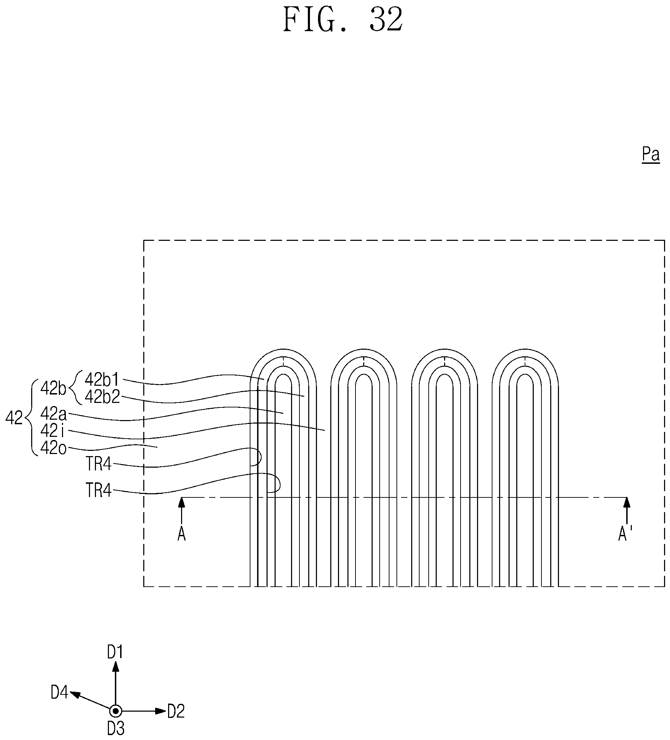

Referring to FIGS. 32 to 35, the first mask layer 40 and the first auxiliary mask layer 45 may be etched using the second mask pattern 52 and the additional mask patterns 92 as an etch mask. As a result, the first mask pattern 42 and a first auxiliary mask pattern 47 may be formed. The first mask pattern 42 may include fourth trenches TR4, and here, the fourth trenches TR4 may be vertically overlapped with the second spacers 87 on the side surfaces of the second mask pattern 52.

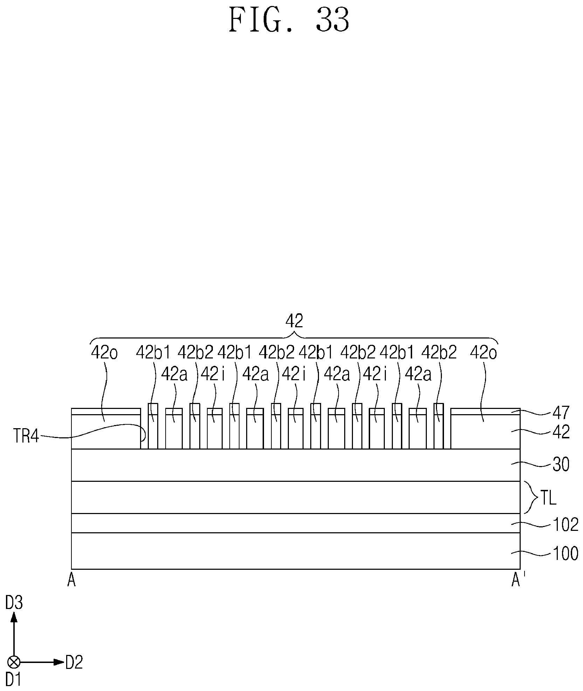

As shown in FIGS. 32 and 33, the first mask pattern 42 may include first mask key patterns 42a, second mask key patterns 42b, inner mask key patterns 42i, and an outer mask key pattern 42o, on the scribe lane region 20. The first mask key patterns 42a, the inner mask key patterns 42i, and the outer mask key pattern 42o may be formed using the additional mask patterns 92 as an etch mask, and thus, the first mask key patterns 42a, the inner mask key patterns 42i, and the outer mask key pattern 42o may be formed using the additional mask patterns 92may be formed at positions that are vertically overlapped with the additional mask patterns 92. The second mask key patterns 42b may be formed using the second mask pattern 52 as an etch mask, and thus, the second mask key patterns 42b may be formed at positions that are vertically overlapped with the second mask pattern 52.

The first mask key patterns 42a may be extended in the first direction D1. Each of the inner mask key patterns 42i may be interposed between adjacent ones of the first mask key patterns 42a. Each of the second mask key patterns 42b may include a first side portion 42b 1, which is extended along one of opposite side surfaces of the first mask key pattern 42a, and a second side portion 42b2, which is extended along the other of the opposite side surfaces of the first mask key pattern 42a.

When measured in the second direction D2, the first and second side portions 42b1 and 42b2 of the second mask key patterns 42b may have the same width. When measured in the second direction D2, the width of the first mask key pattern 42a may be larger than the width of each of the first and second side portions 42b 1 and 42b2 and such a difference may be larger than 0 nm and may be smaller than or equal to 10 nm. When measured in the second direction D2, the width of the inner mask key pattern 42i may be larger than the width of each of the first and second side portions 42b 1 and 42b2 and such a difference may be larger than 0 nm and may be smaller than or equal to 10 nm. The widths of the first mask key pattern 42a and the inner mask key pattern 42i measured in the second direction D2 may be substantially equal to each other or may be different from each other. The widths of the fourth trenches TR4 measured in the second direction D2 may be substantially equal to each other.

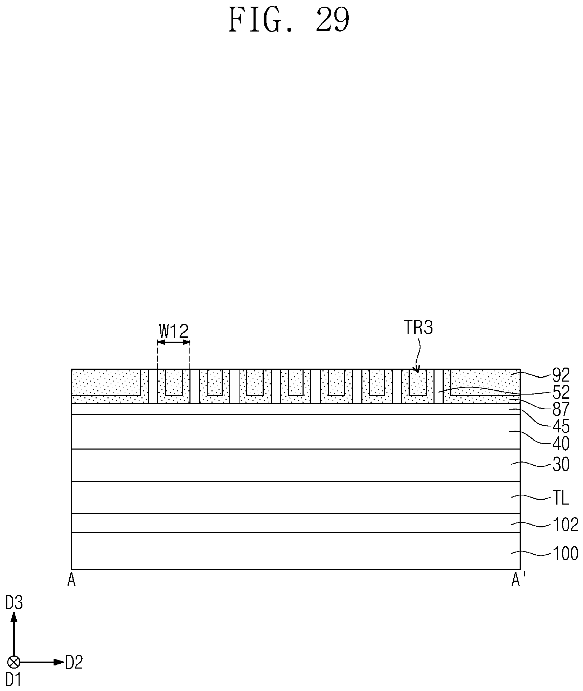

The first auxiliary mask pattern 47 may be formed on the first mask key patterns 42a, the second mask key patterns 42b, the inner mask key patterns 42i, and the outer mask key pattern 42o. Due to a difference in etch selectivity between the second spacers 87 and the second mask pattern 52 on the bottom surfaces of the third trenches TR3 of FIG. 29, a thickness of the first auxiliary mask pattern 47 in the third direction D3 may vary from region to region. As an example, a thickness of the first auxiliary mask pattern 47 on the second mask key patterns 42b may be larger than thicknesses of the first auxiliary mask pattern 47 on the first mask key patterns 42a, the inner mask key patterns 42i, and the outer mask key pattern 42o.

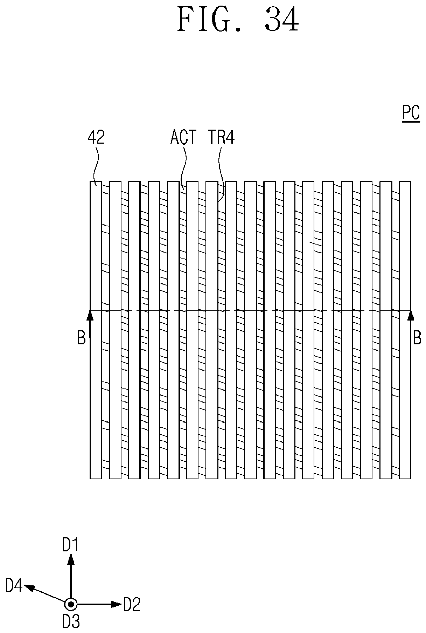

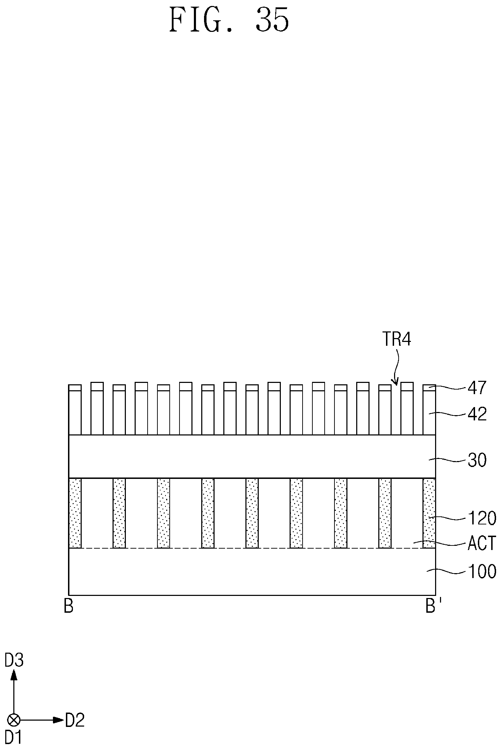

As shown in FIGS. 34 and 35, the first mask patterns 42 may be formed on the chip region 10. On the chip region 10, the first mask patterns 42 may be provided to have substantially the same width in the second direction D2. Although the third pitch P3 is different from the fourth pitch P4, the width of each of the first mask patterns 42 on the chip region 10 may be substantially equal to the width of each of the first and second side portions 42b1 and 42b2 on the scribe lane region 20. This is because the first mask patterns 42 and the first and second side portions 42b1 and 42b2 on the chip region 10 are formed along the second mask pattern 52 and the second mask pattern 52 is formed from the first spacers 82. Accordingly, the first mask patterns 42 and the first and second side portions 42b 1 and 42b2 on the chip region 10 may have substantially the same width, regardless of the difference between the third and fourth pitches P3 and P4. The width of each of the first mask patterns 42 on the chip region 10 may be smaller than the widths of the first mask key pattern 42a and the inner mask key pattern 42i. On the chip region 10, the first mask patterns 42 may have the fourth trenches TR4, and in this case, widths of the fourth trenches TR4 in the second direction D2 may be substantially equal to each other. When viewed in a plan view, a pair of the fourth trenches TR4, which are adjacent to each other in the second direction D2, may be provided to cross the active patterns ACT.

Referring back to FIGS. 4 to 9, a lower mask pattern (not shown) may be formed by etching the lower mask layer 30 using the first mask pattern 42 as an etch mask. Thereafter, the lower mask pattern may be used as an etch mask in a process of etching the target layer TL on the scribe lane region 20 and etching the device isolation pattern 120 and the active patterns ACT on the chip region 10.

On the scribe lane region 20, a remaining portion of the target layer TL may constitute the first key patterns K1, the second key patterns K2, the inner patterns IP, and the outer pattern OP. The first key patterns K1 may be formed in regions, which are vertically overlapped with the first mask key patterns 42a of FIG. 32. The second key patterns K2 may be formed in regions, which are vertically overlapped with the second mask key patterns 42b of FIG. 32. For example, the first portions K2a of the second key patterns K2 may be formed in regions, which are vertically overlapped with the first side portions 42b1 of the second mask key patterns 42b, and the second portions K2b may be formed in regions, which are vertically overlapped with the second side portions 42b2. The inner patterns IP may be formed in regions, which are vertically overlapped with the inner mask key patterns 42i of FIG. 32. The outer pattern OP may be formed in a region, which is vertically overlapped with the outer mask key pattern 42o of FIG. 32. Trenches may be formed in regions, which are in the target layer TL and vertically overlapped with the fourth trenches TR4 of FIG. 32, and the third key patterns K3 may be formed to fill the trenches. The first to third key patterns K1, K2, and K3 may constitute the fine key pattern FP. The fine key patterns FP, the inner patterns IP, and the outer pattern OP may constitute or correspond to the key pattern layer KPL.

Trenches may be formed in the active patterns ACT and the device isolation pattern 120 on the chip region 10 to be vertically overlapped with the fourth trenches TR4 of FIG. 34. The word lines WL may be formed in the trenches, respectively, which are formed in the active patterns ACT and the device isolation pattern 120.

Thereafter, a buffer layer (not shown) and a poly-silicon layer (not shown) may be formed to cover the active patterns ACT and the device isolation pattern 120, and the first recess regions RS1 may be respectively formed in upper portions of the active patterns ACT and the device isolation pattern 120. During this process, the buffer layer and the poly-silicon layer may be partially removed to form the buffer pattern 210 and the polysilicon pattern 310.

The bit line contact DC, the bit line BL, and the bit line capping pattern 350 may be formed on the first recess region RS1. The formation of the bit line contact DC, the bit line BL, and the bit line capping pattern 350 may include forming a bit line contact layer (not shown) to fill the first recess region RS1, sequentially forming a bit line layer (not shown) and a bit line capping layer (not shown) on the bit line contact layer, and etching the bit line contact layer, the bit line layer, and the bit line capping layer to form the bit line contact DC, the bit line BL, and the bit line capping pattern 350. During this process, an internal portion of the first recess region RS1 may be partially exposed to the outside again. Thereafter, the first and second gapfill patterns 250 may be sequentially formed to fill a remaining portion of the first recess region RS1.

The bit line spacer SPC may be formed to cover the side surface of the bit line BL and the side surface of the bit line capping pattern 350. The formation of the bit line spacer SPC may include depositing a first bit line spacer layer (not shown) to conformally cover the side surface of the bit line BL and the bit line capping pattern 350, removing a portion of the first bit line spacer layer to form the first bit line spacers 323 separated from each other, depositing a second bit line spacer layer (not shown) to conformally cover the first bit line spacer 323, and removing a lower portion of the second bit line spacer layer between adjacent ones of the bit lines BL to form the second bit line spacer 325.

The storage node contact BC may be formed between adjacent ones of the bit lines BL. The formation of the storage node contact BC may include forming the second recess region RS2 to expose each of the active patterns ACT, forming a storage node contact layer (not shown) to fill the second recess region RS2, and removing an upper portion of the storage node contact layer to form the storage node contacts BC separated from each other. The second recess region RS2 may be formed below a region, from which the lower portion of the second bit line spacer layer is removed. The removal of the upper portion of the storage node contact layer may further include an etch-back or polishing process, but example embodiments are not limited to this example.

Fence patterns (not shown) may be formed between adjacent ones of the bit lines BL. The fence patterns may separate the storage node contacts BC from each other in the second direction D2. In some example embodiments, the fence patterns may be formed before the formation of the storage node contacts BC, and the storage node contacts BC may be formed between adjacent ones of the bit lines BL and between the fence patterns, which are adjacent to each other in the second direction D2. In some example embodiments, after the formation of the storage node contacts BC, the fence patterns may be formed between adjacent ones of the bit lines BL and between the storage node contacts BC, which are adjacent to each other in the second direction D2.

Thereafter, the second barrier pattern 410 may be formed on the bit line spacer SPC and the storage node contact BC to conformally cover the bit line spacer SPC and the storage node contact BC. A second ohmic pattern (not shown) may be further formed between the second barrier pattern 410 and the storage node contact BC.

The landing pad LP may be formed on the storage node contact BC. The formation of the landing pad LP may include sequentially forming a landing pad layer (not shown) and mask patterns (not shown) to cover top surfaces of the storage node contact BC and dividing the landing pad layer into a plurality of landing pads LP through an anisotropic etching process using the mask patterns as an etch mask. As a result of the etching process, a portion of the second barrier pattern 410, a portion of the bit line spacer SPC, and a portion of the bit line capping pattern 350 may be further etched and may be exposed, e.g. exposed to the outside. Thereafter, the filling pattern 440 may be formed to cover the exposed portions and to enclose each of the landing pads LP, and the data storage patterns DSP may be formed on the landing pads LP, respectively.

During the elements located at a level higher than the word lines WL are formed on the chip region 10, the upper pattern layer 104 may be formed at a level higher than the key pattern layer KPL, on the scribe lane region 20. Example embodiments are not limited to a specific material of the upper pattern layer 104.

According to some example embodiments, after a patterning process for forming a key pattern, the key patterns on a scribe lane region may be formed to have widths and/or pitches that are different from patterns on a chip region. Accordingly, it may be possible to reduce a process failure, which may occur in a process of forming a fine pattern on the scribe lane region. Alternatively or additionally, by virtue of the reduction of the process failure, it may be possible to more easily form the key patterns and thereby to form a process-monitoring structure allowing for an easy or easier process-monitoring operation.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Moreover, when the words "generally" and "substantially" are used in connection with material composition, it is intended that exactitude of the material is not required but that latitude for the material is within the scope of the disclosure.

Further, regardless of whether numerical values or shapes are modified as "about" or "substantially," it will be understood that these values and shapes should be construed as including a manufacturing or operational tolerance (e.g., ±10%) around the stated numerical values or shapes. Thus, while the term "same," "identical," or "equal" is used in description of example embodiments, it should be understood that some imprecisions may exist. Thus, when one element or one numerical value is referred to as being the same as another element or equal to another numerical value, it should be understood that an element or a numerical value is the same as another element or another numerical value within a desired manufacturing or operational tolerance range (e.g., ±10%).

While various example embodiments of the inventive concept have been particularly shown and described, it will be understood by one of ordinary skill in the art that variations in form and detail may be made therein without departing from the scope of the attached claims. Furthermore example embodiments are not necessarily mutually exclusive with one another. For example, some example embodiments may include one or more features described with reference to one or more drawings, and may also include one or more other features described with reference to one or more other drawings.

## Claims

1. A semiconductor device, comprising:
a substrate (100) including a chip region (10) and an edge region (23) enclosing the chip region (10); and
at least one coarse key pattern (CP) at least partly divided into fine key patterns (FP) on the edge region (23), extending in a first direction and spaced apart from each other in a second direction that crosses the first direction,
wherein each of the fine key patterns (FP) comprise:
a first key pattern (K1) extending in the first direction; and
a second key pattern (K2) comprising a first portion (K2a) extending along a side surface (K1s) of the first key pattern (K1), and a second portion (K2b) extending along an opposite side surface (K1s) of the first key pattern (K1),
wherein each of the first and second portions (K2a and K2b) have widths that are less than a width of the first key pattern (K1), when measured in the second direction.

2. The semiconductor device of claim 1, wherein the first portion, the first key pattern, and the second portion are sequentially arranged in the second direction.

3. The semiconductor device of claim 1 or 2, wherein the width of the first portion is substantially equal to the width of the second portion.

4. The semiconductor device of any preceding claim, wherein
the at least one coarse key pattern comprises a first coarse key pattern extending in the first direction, and a second coarse key pattern extending in the second direction, and
each of the fine key patterns of the first coarse key pattern is elongated in the first direction to have a length that is larger than each of the fine key patterns of the second coarse key pattern.

5. The semiconductor device of claim 4, wherein a number of the fine key patterns of the first coarse key pattern is less than a number of the fine key patterns of the second coarse key pattern.

6. The semiconductor device of any preceding claim 1, wherein a first pitch of each of the fine key patterns in the second direction ranges from 80 nm to 150 nm.

7. The semiconductor device of any preceding claim 1, wherein the at least one coarse key pattern further comprises inner patterns between the fine key patterns which are adjacent to each other in the second direction.

8. The semiconductor device of claim 7, wherein the fine key patterns and the inner patterns are alternately arranged in the second direction.

9. The semiconductor device of claim 7 or 8, wherein the first portions, the first key patterns, the second portions, and the inner patterns are alternately arranged in the second direction.

10. The semiconductor device of claim 7, 8 or 9, wherein each of the fine key patterns further comprises third key patterns interposed between the first and second key patterns and between the second key pattern and the inner pattern adjacent thereto.

11. The semiconductor device of claim 10, wherein the third key patterns have substantially the same width in the second direction.

12. The semiconductor device of any one of claims 7 to 11, wherein a width of each of the inner patterns is substantially equal to the width of the first key pattern, when measured in the second direction.

13. The semiconductor device of any one of claims 7 to 12, wherein a width of each of the inner patterns is greater than a width of each of the first and second portions, when measured in the second direction.
